# EUROPEAN PATENT APPLICATION

(11) **EP 3 733 730 A1**
(43) Date of publication of application: **04.11.2020**
(21) Application number: 18895699.9
(22) Date of filing: 18.12.2018
(51) Int. Cl.: C08G 59/32, C08G 65/18, C08G 75/045, C08K 3/38, C08L 63/00, H01L 23/373

(54) **COMPOSITION, THERMALLY CONDUCTIVE MATERIAL, DEVICE HAVING THERMAL CONDUCTION LAYER, AND METHOD OF PRODUCING THERMALLY CONDUCTIVE MATERIAL**

(30) Priority: 27.12.2017 JP 2017252328
(71) Applicant: Fujifilm Corporation, Minato-ku Tokyo 106-8620 (JP)
(72) Inventor: HITOMI, Seiichi, Ashigara-kami-gun, Kanagawa 258-8577 (JP); TAKAHASHI, Keita, Ashigara-kami-gun, Kanagawa 258-8577 (JP); NIORI, Teruki, Ashigara-kami-gun, Kanagawa 258-8577 (JP); YOSHIDA, Yuji, Ashigara-kami-gun, Kanagawa 258-8577 (JP)
(74) Representative: Hoffmann Eitle
(86) International application number: PCT/JP2018/046579
(87) International publication number: WO 2019/131332

(57) **Abstract**

A first object of the present invention is to provide a composition capable of forming a cured product (thermally conductive material) having excellent thermal conductivity. In addition, a second object of the present invention is to provide a thermally conductive material formed from the composition and a device with a thermally conductive layer. In addition, a third object of the present invention is to provide a method for manufacturing a thermally conductive material using the composition.

The composition of the present invention includes a curing agent including an active hydrogen-containing functional group, and a main agent including a reactive group which reacts with the active hydrogen-containing functional group, in which the main agent and the curing agent respectively exhibit liquid crystallinity in a single state at a temperature of 150°C or lower.

## Description

### BACKGROUND OF THE INVENTION

### 1. Field of the Invention

The present invention relates to a composition, a thermally conductive material, a device with a thermally conductive layer, and a method for manufacturing a thermally conductive material.

### 2. Description of the Related Art

In recent years, power semiconductor devices used for various electric devices such as personal computers, general home electric appliances, and automobiles have been rapidly progressed in miniaturization. With the miniaturization, it has become difficult to control heat generated from a high-density power semiconductor device.

In order to cope with such a problem, a thermally conductive material which promotes heat release from the power semiconductor device has been used.

For example, WO2016/104772A discloses an epoxy resin having excellent thermal conductivity, "which has a mesogen skeleton and is obtained by reacting an epoxy resin monomer having two glycidyl groups in one molecule with a dihydric phenol compound having two hydroxyl groups in one benzene ring as a substituent, in which a number-average molecular weight in a gel permeation chromatography measurement is 600 to 2500".

### SUMMARY OF THE INVENTION

The present inventors have studied the epoxy resin (thermally conductive material) disclosed in WO2016/104772A, and have found that the epoxy resin disclosed in WO2016/104772A does not meet the recently required level of thermal conductivity and further improvement is needed.

Therefore, an object of the present invention is to provide a composition capable of forming a cured product (thermally conductive material) having excellent thermal conductivity.

In addition, another object of the present invention is to provide a thermally conductive material formed from the composition and a device with a thermally conductive layer.

In addition, another object of the present invention is to provide a method for manufacturing a thermally conductive material using the composition.

The present inventors have conducted intensive studies to achieve the above-described object, and as a result, found that the object can be achieved by using a compound exhibiting liquid crystallinity as a main agent and a curing agent, and completed the present invention.

That is, the present inventors have found that the object can be achieved by the following configuration.
[1] A composition comprising:
   a curing agent including an active hydrogen-containing functional group; and
   a main agent including a reactive group which reacts with the active hydrogen-containing functional group,
   in which the curing agent and the main agent respectively exhibit liquid crystallinity in a single state at a temperature of 150°C or lower.
[2] The composition according to [1],
   in which the curing agent and the main agent respectively exhibit nematic liquid crystallinity in a single state at a temperature of 150°C or lower.
[3] The composition according to [1] or [2],
   in which the main agent includes a ring-polymerizable group.
[4] The composition according to any one of [1] to [3],
   in which the curing agent is a disk-like compound.
[5] The composition according to any one of [1] to [4],
   in which the main agent is a disk-like compound.
[6] The composition according to any one of [1] to [5],
   in which both of the curing agent and the main agent is a disk-like compound.
[7] The composition according to any one of [4] to [6],
   in which the disk-like compound is a disk-like compound selected from the group consisting of a disk-like compound including a partial structure represented by Formula (CR4) described later and a disk-like compound including a partial structure represented by Formula (CR16) described later.
[8] The composition according to any one of [1] to [7], further comprising:
   an inorganic substance.
[9] The composition according to [8],
   in which the inorganic substance is an inorganic nitride or an inorganic oxide.
[10] The composition according to [8] or [9],
   in which an average particle diameter of the inorganic substance is 20 µm or more.
[11] The composition according to [8] or [9],
   in which the inorganic substance is boron nitride.
[12] The composition according to any one of [1] to [11], which exhibits nematic liquid crystallinity.
[13] The composition according to any one of [1] to [12], which is used for forming a thermally conductive material.
[14] A method for manufacturing a thermally conductive material, the method comprising:
   a step 1 of forming a composition layer using the composition according to any one of [1] to [13];
   a step 2 of heating the composition layer to a temperature of 150°C or lower, at which both of the curing agent and the main agent exhibits liquid crystallinity, to align the curing agent and the main agent; and
   a step 3 of curing the composition layer.
[15] The method for manufacturing a thermally conductive material according to [14],
   in which the step 3 is a curing step using a thermosetting method.
[16] A thermally conductive material formed by using the composition according to any one of [1] to [13].
[17] The thermally conductive material according to [16], which is obtained by fixing a nematic liquid crystal phase.
[18] The thermally conductive material according to [16] or [17], which is in a form of a sheet.
[19] A device with a thermally conductive layer comprising:
   a device; and
   a thermally conductive layer which is disposed on the device and includes the thermally conductive material according to any one of [16] to [18].

According to the present invention, it is possible to provide a composition capable of forming a cured product (thermally conductive material) having excellent thermal conductivity.

In addition, according to the present invention, it is possible to provide a thermally conductive material formed from the composition and a device with a thermally conductive layer.

In addition, according to the present invention, it is possible to provide a method for manufacturing a thermally conductive material using the composition.

### DESCRIPTION OF THE PREFERRED EMBODIMENTS

Hereinafter, a composition, a thermally conductive material, a device with a thermally conductive layer, and a method for manufacturing a thermally conductive material of the
present invention will be described in detail.

The description of constituent elements described below is made based on representative embodiments of the present invention, but the present invention is not limited to such embodiments.

In the present specification, a numerical range represented by using "to" means a range including numerical values described before and after "to" as a lower limit value and an upper limit value.

In addition, in the present specification, an oxiranyl group is a functional group which is also referred to as an epoxy group, and for example, includes a group in which an oxirane ring is formed by bonding two carbon atoms adjacent to a saturated hydrocarbon ring group with an oxo group (-O-).

In addition, in the present specification, the description of "(meth)acryloyl group" means "either or both of an acryloyl group and a methacryloyl group". In addition, in the present specification, the description of "(meth)acrylamide group" means "either or both of an acrylamide group and a methacrylamide group".

In addition, in the present specification, in a case of the description of "may have a substituent", the type of the substituent, the position of the substituent, and the number of substituents are not particularly limited. Examples of the number of substituents include one or two or more. Examples of the substituent include a monovalent nonmetallic atomic group excluding a hydrogen atom, and for example, is selected from the following substituent group Y.

Substituent group Y:
a halogen atom (-F, -Br, -Cl, or -I), a hydroxyl group, an amino group, a carboxy group and a conjugate base group thereof, a carboxylic acid anhydride group, a cyanate ester group, an unsaturated polymerizable group, an oxiranyl group, an oxetanyl group, an aziridinyl group, a thiol group, an isocyanate group, a thioisocyanate group, an aldehyde group, an alkoxy group, an aryloxy group, an alkylthio group, an arylthio group, an alkyldithio group, an aryldithio group, a N-alkylamino group, a N,N-dialkylamino group, a N-arylamino group, a N,N-diarylamino group, a N-alkyl-N-arylamino group, an acyloxy group, a carbamoyloxy group, a N-alkylcarbamoyloxy group, a N-arylcarbamoyloxy group, a N,N-dialkylcarbamoyloxy group, a N,N-diarylcarbamoyloxy group, a N-alkyl-N-arylcarbamoyloxy group, an alkylsulfoxy group, an arylsulfoxy group, an acylthio group, an acylamino group, a N-alkylacylamino group, a N-arylacylamino group, a ureide group, a N'-alkylarylureide group, a N',N'-dialkylureide group, a N'-arylureide group, a N',N'-diarylureide group, a N'-alkyl-N-arylureide group, a N-alkylureide group, a N-arylureide group, a N'-alkyl-N-alkylureide group, a N'-alkyl-N-arylureide group, a N',N'-dialkyl-N-alkylureide group, a N',N'-dialkyl-N-arylureide group, a N'-aryl-N-alkylureide group, a N'-aryl-N-arylureide group, a N',N'-diaryl-N-alkylureide group, a N',N'-diaryl-N-arylureide group, a N'-alkyl-N'-aryl-N-alkylureide group, a N'-alkyl-N'-aryl-N-arylureide group, an alkoxycarbonylamino group, an aryloxycarbonylamino group, a N-alkyl-N-alkoxycarbonylamino group, a N-alkyl-N-aryloxycarbonylamino group, a N-aryl-N-alkoxycarbonylamino group, a N-aryl-N-aryloxycarbonylamino group, a formyl group, an acyl group, an alkoxycarbonyl group, an aryloxycarbonyl group, a carbamoyl group, a N-alkylcarbamoyl group, a N,N-dialkylcarbamoyl group, a N-arylcarbamoyl group, a N,N-diarylcarbamoyl group, a N-alkyl-N-arylcarbamoyl group, an alkylsufinyl group, an arylsulfinyl group, an alkylsulfonyl group, an arylsulfonyl group, a sulfo group (-SO₃H) and a conjugate base group thereof, an alkoxysulfonyl group, an aryloxysulfonyl group, a sulfinamoyl group, a N-alkylsulfinamoyl group, a N,N-dialkylsulfinamoyl group, a N-arylsulfinamoyl group, a N,N-diarylsulfinamoyl group, a N-alkyl-N-arylsulfinamoyl group, a sulfamoyl group, a N-alkylsulfamoyl group, a N,N-dialkylsulfamoyl group, a N-arylsulfamoyl group, a N,N-diarylsulfamoyl group, a N-alkyl-N-arylsulfamoyl group, a N-acylsulfamoyl group and a conjugate base group thereof, a N-alkylsulfonylsulfamoyl group (-SO₂NHSO₂(alkyl)) and a conjugate base group thereof, a N-arylsulfonylsulfamoyl group (-SO₂NHSO₂(aryl)) and a conjugate base group thereof, a N-alkylsulfonylcarbamoyl group (-CONHSO₂(alkyl)) and a conjugate base group thereof, a N-arylsulfonylcarbamoyl group (-CONHSO₂(aryl)) and a conjugate base group thereof, an alkoxysilyl group (-Si(Oalkyl)₃), an aryloxysilyl group (-Si(Oaryl)₃), a hydroxysilyl group (-Si(OH)₃) and a conjugate base group thereof, a phosphono group (-PO₃H₂) and a conjugate base group thereof, a dialkylphosphono group (-PO₃(alkyl)₂), a diarylphosphono group (-PO₃(aryl)₂), an alkylarylphosphono group (-PO₃(alkyl)(aryl)), a monoalkylphosphono group (-PO₃H(alkyl)) and a conjugate base group thereof, a monoarylphosphono group (-PO₃H(aryl)) and a conjugate base group thereof, a phosphonooxy group (-OPO₃H₂) and a conjugate base group thereof, a dialkylphosphonooxy group (-OPO₃(alkyl)₂), a diarylphosphonooxy group (-OPO₃(aryl)₂), an alkylarylphosphonooxy group (-OPO₃(alkyl)(aryl)), a monoalkylphosphonooxy group (-OPO₃H(alkyl)) and a conjugate base group thereof, a monoarylphosphonooxy group (-OPO₃H(aryl)) and a conjugate base group thereof, a cyano group, a nitro group, an aryl group, an alkenyl group, n alkynyl group, and an alkyl group.

These substituents may form a ring with each other if possible or may form a ring by being bonded to the group substituted with the substituents.

Examples of the unsaturated polymerizable group include a (meth)acryloyl group, a (meth)acrylamide group, and substituents represented by Q1 to Q7 shown below.

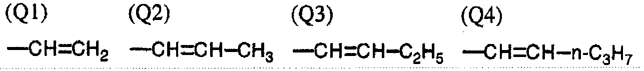

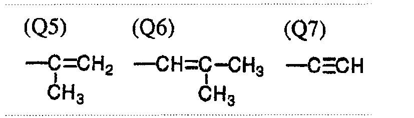

### [Composition]

The composition according to an embodiment of the present invention includes a curing agent including an active hydrogen-containing functional group, and a main agent including a reactive group which reacts with the active hydrogen-containing functional group, in which the curing agent and the main agent respectively exhibit liquid crystallinity in a single state at a temperature of 150°C or lower.

In the present specification, the description of "exhibit liquid crystallinity in a single state at a temperature of 150°C or lower" means that a compound functioning as the curing agent or a compound functioning as the main agent exhibits liquid crystallinity in a single state (in other words, in a state not mixed with other components) at a temperature of 150°C or lower. The lower limit value is not particularly limited, but is, for example, room temperature (25°C) or higher.

In addition, the description of "exhibit liquid crystallinity at a temperature of 150°C or lower" means that it is sufficient that the compounds have a liquid crystal phase at least at a temperature of 150°C or lower. That is, the description corresponds to a case (1) where the compounds have a phase transition temperature of crystal phase to liquid crystal phase of 150°C or lower and have a phase transition temperature of isotropic phase to liquid crystal phase of 150°C or lower, or a case (2) where the compounds have a phase transition temperature of crystal phase to liquid crystal phase of 150°C or lower and have a phase transition temperature of isotropic phase to liquid crystal phase of higher than 150°C.

Liquid crystallinity of the compounds can be confirmed by observation with a polarizing microscope or measurement of differential scanning calorimetry.

The present inventors have found that, in a case where a composition including a main agent and a curing agent capable of reacting with the main agent is a compound in which the main agent and the curing agent each independently exhibit liquid crystallinity at a temperature of a predetermined temperature or lower, thermal conductivity of the obtained cured product (thermally conductive material) is dramatically improved.

In a case where the composition forms a thermally conductive material, it is preferable that a coating film (composition layer) of the composition is heated at a temperature in which both of the curing agent and the main agent in the composition layer exhibits liquid crystallinity (preferably nematic liquid crystallinity) and a curing reaction of the curing agent and the main agent does not substantially proceed, and a thermosetting treatment is performed after aligning the curing agent and the main agent. A thermosetting reaction is usually started at a temperature higher than 150°C. Therefore, since the curing agent and the main agent in the composition exhibit liquid crystallinity at a temperature of 150°C or lower, the alignment of the liquid crystal component occurs in preference to the thermosetting reaction and a cured product (thermally conductive material) having high order parameter is obtained. In addition, it has been confirmed that, by performing the thermosetting treatment as a curing reaction, compared with a case of photo-curing treatment, the reaction of the main agent and the curing agent respectively exhibiting liquid crystallinity is more promoted and thermal conductivity of the obtained thermally conductive material is more excellent.

In addition, in a case where both of the curing agent and the main agent is a disk-like compound, thermal conductivity of the obtained cured product is more excellent. Since the disk-like compound can have multiple side chains which include a reactive group and are arranged radially to the central nucleus (that is, the thermal conduction path is easily expanded), it is considered that the disk-like compound has excellent thermal conductivity.

In addition, it is preferable that the liquid crystal phase exhibited in the curing agent and the main agent at a temperature range of 150°C or lower is a nematic liquid crystal phase. A thermally conductive material formed from the composition according to the embodiment of the present invention has high thermal conductivity required for a thermal conduction sheet even in the nematic liquid crystal phase having a relatively low order parameter.

In addition, in a case where the composition according to the embodiment of the present invention includes an inorganic substance, thermal conductivity of the thermally conductive material is further improved. Even in a case where the composition according to the embodiment of the present invention does not include the inorganic substance (in other words, in a case where the composition according to the embodiment of the present invention is formed only of an organic substance), the thermally conductive material has high thermal conductivity required for a thermal conduction sheet.

Hereinafter, components included in the composition will be described in detail.

### [Curing agent]

The composition according to the embodiment of the present invention includes a curing agent. The curing agent includes an active hydrogen-containing functional group and exhibits liquid crystallinity in a single state at a temperature of 150°C or lower.

In the present specification, "active hydrogen" means a hydrogen atom directly bonded to a nitrogen atom, an oxygen atom, or a sulfur atom.

The active hydrogen-containing functional group included in the curing agent is not particularly limited as long as a functional group including the active hydrogen, and is preferably, for example, an amino group, a thiol group, a hydroxyl group, or a carboxy group.

The type of the active hydrogen-containing functional group included in the curing agent is appropriately selected according to the type of the reactive group in the main agent used in combination.

Examples of a reactive group capable of using in a case where the active hydrogen-containing functional group is an amino group include an oxiranyl group, an oxetanyl group, a carboxy group, a benzyl halide group, an isocyanate group, an aldehyde group, and a carbonyl group.

Examples of a reactive group capable of using in a case where the active hydrogen-containing functional group is a thiol group include a vinyl group, an oxiranyl group, an oxetanyl group, a benzyl halide group, a carboxylic acid anhydride group, an isocyanate group, and an alkoxysilyl group.

Examples of a reactive group capable of using in a case where the active hydrogen-containing functional group is a hydroxyl group include an oxiranyl group, an oxetanyl group, a benzyl halide group, a carboxylic acid anhydride group, an isocyanate group, and an alkoxysilyl group.

Examples of a reactive group capable of using in a case where the active hydrogen-containing functional group is a carboxy group include an oxiranyl group, an oxetanyl group, a benzyl halide group, a cyanate ester group, an amino group, an isocyanate group, and an aziridine group.

It is sufficient that the curing agent exhibits liquid crystallinity in a single state at least at a temperature range of 150°C or lower. From the viewpoint that thermal conductivity of the thermally conductive material is more excellent, it is preferable that the curing agent has a phase transition temperature of crystal phase to liquid crystal phase of lower than 150°C and has a phase transition temperature of isotropic phase to liquid crystal phase of 200°C or lower, and it is more preferable that the curing agent has a phase transition temperature of crystal phase to liquid crystal phase of 130°C or lower and has a phase transition temperature of isotropic phase to liquid crystal phase of 180°C or lower.

In addition, it is preferable that the liquid crystal phase exhibited in the curing agent at a temperature range of 150°C or lower is a nematic liquid crystal phase.

The curing agent may be used singly or in combination of two or more thereof.

The content of the curing agent in the composition is preferably 10% to 90% by mass, more preferably 20% to 80% by mass, and still more preferably 20% to 70% by mass with respect to the total solid content of the composition. The solid content may be any component which constitutes the thermally conductive material, and includes a form of liquid.

As the curing agent, a compound (rod-like compound) at least partially including a rod-like structure or a compound (disk-like compound) at least partially including a disk-like structure is preferable, and from the viewpoint that thermal conductivity of the thermally conductive material is more excellent, the disk-like compound is more preferable.

As a reason for that thermal conductivity of the thermally conductive material is more excellent in a case of using the disk-like compound as the curing agent, it is considered that the disk-like compound can flatwise (two-dimensionally) conduct heat in a normal direction with respect that the rod-like compound con only linearly (one-dimensionally) conduct heat. That is, in a case of using the disk-like compound as the curing agent, more thermal conduction paths are formed, and as a result, it is considered that the thermal conductivity is improved.

In addition, by using the disk-like compound, heat resistance of the cured product of the composition is improved.

Hereinafter, the rod-like compound and the disk-like compound will be described.

### <Rod-like compound>

In a case where the curing agent is the rod-like compound, examples of the rod-like structure include azomethines, azoxies, cyanobiphenyls, cyanophenyl esters, benzoic acid esters, cyclohexane carboxylic acid phenyl esters, cyanophenyl cyclohexanes, cyano-substituted phenylpyrimidines, alkoxy-substituted phenylpyrimidines, phenyldioxanes, tolans, and alkenylcyclohexyl benzonitriles. In addition to these low-molecular weight liquid crystal compounds, high-molecular weight liquid crystal compounds can also be used. The above-mentioned high-molecular weight liquid crystal compounds are polymer compounds obtained by polymerizing low-molecular weight liquid crystal compounds having a low-molecular weight reactive group and the rod-like structure.

In addition, it is preferable that the rod-like compound includes two or more active hydrogen-containing functional groups.

Suitable aspects in a case where the curing agent is the rod-like compound will be described later, together with suitable aspects in a case where the main agent is the rod-like compound.

### <Disk-like compound>

The disk-like compound has at least partially the disk-like structure.

The disk-like structure has at least an alicyclic ring or an aromatic ring. In particular, in a case where the disk-like structure has an aromatic ring, the disk-like compound can form a columnar structure by forming a stacking structure based on the intermolecular π-π interaction.

Specific examples of the disk-like structure include the triphenylene structure disclosed in Angew. Chem. Int. Ed. 2012, 51, 7990-7993 and JP1995-306317A (JP-H07-306317A), and the trisubstituted benzene structure disclosed in JP2007-002220A and JP2010-244038A.

It is preferable that the disk-like compound includes three or more active hydrogen-containing functional groups. A cured product of a composition including the disk-like compound which includes three or more active hydrogen-containing functional groups has high glass transition temperature and tends to have high heat resistance. This is because, as compared with the rod-like compound, the disk-like compound is less affected in the characteristics of the mesogenic moiety even in a case of including three or more active hydrogen-containing functional groups. The number of active hydrogen-containing functional groups included in the disk-like compound is preferably 8 or less and more preferably 6 or less.

Specific examples of the disk-like compound include compounds disclosed in C. Destrade et al., Mol. Cryst. Liq. Cryst., vol. 71, page 111 (1981); The Chemical Society of Japan, Kagaku-Sosetsu, No 22, Chemistry of Liquid crystal, Chapter 5 and Chapter 10, section 2 (1994); B. Kohne et al., Angew. Chem. Soc. Chem. Soc., page 1794 (1985); J. Zhang et al., J. Am. Chem. Soc., vol. 116, page 2655 (1994); and JP4592225B. Examples of the disk-like compound include the triphenylene structure disclosed in Angew. Chem. Int. Ed. 2012, 51, 7990-7993 and JP1995-306317A (JP-H07-306317A), and the trisubstituted benzene structure disclosed in JP2007-002220A and JP2010-244038A.

Suitable aspects in a case where the curing agent is the disk-like compound will be described later, together with suitable aspects in a case where the main agent is the disk-like compound.

### [Main agent]

The composition according to the embodiment of the present invention includes a main agent. The main agent includes a reactive group reacting with the active hydrogen-containing functional group in the above-described curing agent and exhibits liquid crystallinity in a single state at a temperature of 150°C or lower.

The reactive group means a polymerizable group and a crosslinkable group, and among these, a polymerizable group is preferable.

The type of the polymerizable group is not particularly limited, and examples thereof include known polymerizable groups. From the viewpoint that reactivity and thermal conductivity of the thermally conductive material due to the reactivity is more excellent, a functional group which can cause an addition polymerization reaction is preferable, a polymerizable ethylenically unsaturated group or a ring-polymerizable group is more preferable, and a ring-polymerizable group is still more preferable.

Specifically, as the polymerizable group, from the viewpoint that thermal conductivity of the thermally conductive material is more excellent, a (meth)acryloyl group, a vinyl group, an oxiranyl group, or an oxetanyl group is preferable, and an oxiranyl group or an oxetanyl group is more preferable. A hydrogen atom in each of these groups may be substituted with another substituent such as a halogen atom.

In addition, examples of the crosslinkable group include a carboxylic acid anhydride group, a halogen atom, an isocyanate group, a cyano group, an aziridinyl group, a thioisocyanate group, and an aldehyde group.

It is sufficient that the main agent exhibits liquid crystallinity in a single state at least at a temperature range of 150°C or lower. However, from the viewpoint that thermal conductivity of the thermally conductive material is more excellent, it is more preferable that the curing agent has a phase transition temperature of crystal phase to liquid crystal phase of lower than 150°C and has a phase transition temperature of isotropic phase to liquid crystal phase of 250°C or lower, and it is more preferable that the curing agent has a phase transition temperature of crystal phase to liquid crystal phase of 100°C or lower and has a phase transition temperature of isotropic phase to liquid crystal phase of 250°C or lower.

In addition, it is preferable that the liquid crystal phase exhibited in the main agent at a temperature range of 150°C or lower is a nematic liquid crystal phase.

The main agent may be used singly or in combination of two or more thereof.

The content of the main agent in the composition is preferably 10% to 90% by mass, more preferably 10% to 80% by mass, and still more preferably 15% to 70% by mass with respect to the total solid content of the composition.

As the main agent, a rod-like compound or a disk-like compound is preferable, and from the viewpoint that thermal conductivity of the thermally conductive material is more excellent, a disk-like compound is more preferable.

As a reason for that thermal conductivity of the thermally conductive material is more excellent in a case of using the disk-like compound as the main agent, it is considered that the disk-like compound can flatwise (two-dimensionally) conduct heat in a normal direction with respect that the rod-like compound con only linearly (one-dimensionally) conduct heat. That is, in a case of using the disk-like compound as the main agent, more thermal conduction paths are formed, and as a result, it is considered that the thermal conductivity is improved.

In addition, by using the disk-like compound, heat resistance of the cured product of the composition is improved.

In addition, from the viewpoint that thermal conductivity of the thermally conductive material is more excellent in a case where compatibility of the curing agent and the main agent is more excellent, it is preferable that both of the curing agent and the main agent is a rod-like compound or a disk-like compound, and it is more preferable that both of the curing agent and the main agent is a disk-like compound. Among these, it is preferable that both of the curing agent and the main agent is a disk-like compound having a partial structure represented by Formula (CR4) described later or a disk-like compound having a partial structure represented by Formula (CR16) described later.

### <Rod-like compound>

In a case where the main agent is the rod-like compound, examples of the rod-like structure include azomethines, azoxies, cyanobiphenyls, cyanophenyl esters, benzoic acid esters, cyclohexane carboxylic acid phenyl esters, cyanophenyl cyclohexanes, cyano-substituted phenylpyrimidines, alkoxy-substituted phenylpyrimidines, phenyldioxanes, tolans, and alkenylcyclohexyl benzonitriles. In addition to these low-molecular weight liquid crystal compounds, high-molecular weight liquid crystal compounds can also be used. The aforementioned high-molecular weight liquid crystal compounds are polymer compounds obtained by polymerizing rod-like compounds having a low-molecular weight reactive group.

In addition, it is preferable that the main agent includes two or more reactive groups.

Suitable aspects in a case where the main agent is the rod-like compound will be described later.

### <Disk-like compound>

The disk-like compound has at least partially the disk-like structure.

The disk-like structure has at least an alicyclic ring or an aromatic ring. In particular, in a case where the disk-like structure has an aromatic ring, the disk-like compound can form a columnar structure by forming a stacking structure based on the intermolecular π-π interaction.

Specific examples of the disk-like structure include the triphenylene structure disclosed in Angew. Chem. Int. Ed. 2012, 51, 7990-7993 or JP1995-306317A (JP-H07-306317A), and the trisubstituted benzene structure disclosed in JP2007-002220A and JP2010-244038A.

In addition, it is preferable that the disk-like compound includes three or more reactive groups. A cured product of a composition including the disk-like compound which includes three or more reactive groups has high glass transition temperature and tends to have high heat resistance. This is because, as compared with the rod-like compound, the disk-like compound is less affected in the characteristics of the mesogenic moiety even in a case of including three or more reactive groups. The number of reactive groups included in the disk-like compound is preferably 8 or less and more preferably 6 or less.

Specific examples of the disk-like compound include compounds disclosed in C. Destrade et al., Mol. Cryst. Liq. Cryst., vol. 71, page 111 (1981); The Chemical Society of Japan, Kagaku-Sosetsu, No 22, Chemistry of Liquid crystal, Chapter 5 and Chapter 10, section 2 (1994); B. Kohne et al., Angew. Chem. Soc. Chem. Soc., page 1794 (1985); J. Zhang et al., J. Am. Chem. Soc., vol. 116, page 2655 (1994); and JP4592225B. Examples of the disk-like compound include the triphenylene structure disclosed in Angew. Chem. Int. Ed. 2012, 51, 7990-7993 and JP1995-306317A (JP-H07-306317A), and the trisubstituted benzene structure disclosed in JP2007-002220A and JP2010-244038A.

Suitable aspects in a case where the main agent is the disk-like compound will be described later.

### [Structure of curing agent and main agent]

Hereinafter, the suitable aspects in a case where the curing agent is the rod-like compound and a case where the main agent is the rod-like compound, and the suitable aspects in a case where the curing agent is the disk-like compound and a case where the main agent is the disk-like compound will be described in detail.

### [Suitable aspects in case where curing agent is rod-like compound and case where main agent is rod-like compound]

In a case where the curing agent is the rod-like compound and a case where the main agent is the rod-like compound, as the rod-like compound, a rod-like compound represented by Formula (XXI) is preferable.

Formula (XXI): Q¹-L¹¹¹-A¹¹¹-L¹¹³-M-L¹¹⁴-A¹¹²-L¹¹²-Q²

In the formula, L¹¹¹, L¹¹², L¹¹³, and L¹¹⁴ each independently represent a single bond or a divalent linking group. A¹¹¹ and A¹¹² each independently represent a divalent linking group (spacer group) having 1 to 20 carbon atoms. M represents a mesogenic group. In addition, Q¹ and Q² each independently represent, in a case where Formula (XXI) is the curing agent, an active hydrogen-containing functional group, and represent, in a case where Formula (XXI) is the main agent, a reactive group.

The definition of the active hydrogen-containing functional group and the definition of the reactive group are as described above.

As the divalent linking group represented by L¹¹¹, L¹¹², L¹¹³, and L¹¹⁴, a divalent linking group selected from the group consisting of -O-, -S-, -C(=O)-, -NR¹¹²-, -C(=O)-O-, -O-C(=O)-O-, -C(=O)-NR¹¹²-, -NR¹¹²-C(=O)-, -O-C(=O)-, -CH₂-O-, -O-CH₂-, -O-C(=O)-NR¹¹²-, -NR¹¹²-C(=O)-O-, and -NR¹¹²-C(=O)-NR¹¹²- is preferable. R¹¹² is an alkyl group having 1 to 7 carbon atoms or a hydrogen atom.

A¹¹¹ and A¹¹² each represent a divalent linking group having 1 to 20 carbon atoms. Among these, an alkylene group having 1 to 12 carbon atoms, an alkenylene group having 1 to 12 carbon atoms, or an alkynylene group having 1 to 12 carbon atoms is preferable, and an alkylene group having 1 to 12 carbon atoms is more preferable.

The divalent linking group is preferably linear and may include oxygen atoms or sulfur atoms which are not adjacent to each other. In addition, the divalent linking group may have a substituent, and examples of the substituent include a halogen atom (a fluorine atom, a chlorine atom, and a bromine atom), a cyano group, a methyl group, and an ethyl group.

Examples of the mesogenic group represented by M include known mesogenic groups. Among these, a group represented by Formula (XXII) is preferable.

Formula (XXII): -(W¹-L¹¹⁵)ₙ-W²-

In the formula, W¹ and W² each independently represent a divalent cyclic alkylene group, a divalent cyclic alkenylene group, an arylene group, or a divalent heterocyclic group. L¹¹⁵ represents a single bond or a divalent linking group. n represents 1, 2, or 3.

Examples of W¹ and W² include 1,4-cyclohexenediyl, 1,4-cyclohexanediyl, 1,4-phenylene, pyrimidine-2,5-diyl, pyridine-2,5-diyl, 1,3,4-thiadiazole-2,5-diyl, 1,3,4-oxadiazole-2,5-diyl, naphthalene-2,6-diyl, naphthalene-1,5-diyl, thiophene-2,5-diyl, and pyridazine-3,6-diyl. In a case of 1,4-cyclohexanediyl, the compound may be any of constitutional isomers of a trans isomer and a cis isomer, or a mixture in which the isomers are mixed at an arbitrary ratio. Among these, a trans isomer is preferable.

Each of W¹ and W² may have a substituent. Examples of the substituent include groups listed in the above-described substituent group Y. More specifically, examples of the substituent include a halogen atom (a fluorine atom, a chlorine atom, a bromine atom, and an iodine atom), a cyano group, an alkyl group having 1 to 10 carbon atoms (for example, a methyl group, an ethyl group, a propyl group, and the like), an alkoxy group having 1 to 10 carbon atoms (for example, a methoxy group, an ethoxy group, and the like), an acyl group having 1 to 10 carbon atoms (for example, a formyl group, an acetyl group, and the like), an alkoxycarbonyl group having 1 to 10 carbon atoms (for example, a methoxycarbonyl group, an ethoxycarbonyl group, and the like), an acyloxy group having 1 to 10 carbon atoms (for example, an acetyloxy group, a propionyloxy group, and the like), a nitro group, a trifluoromethyl group, and a difluoromethyl group.

Examples of the divalent linking group represented by L¹¹⁵ include the specific examples of the divalent linking group represented by L¹¹¹ to L¹¹⁴ described above, such as -C(=O)-O-, -O-C(=O)-, -CH₂-O-, and -O-CH₂-.

Examples of a preferable structure as a basic skeleton of the mesogenic group represented by Formula (XXII) will be shown below. These structures may be substituted with the above-described substituent.

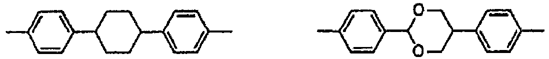

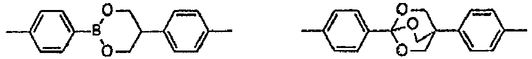

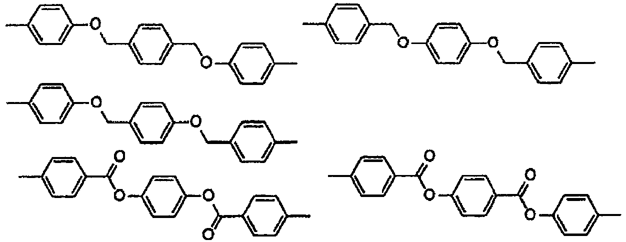

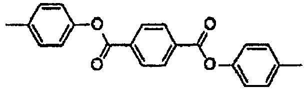

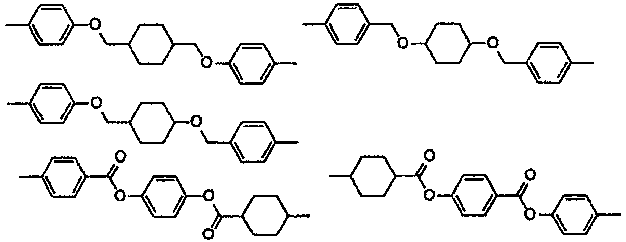

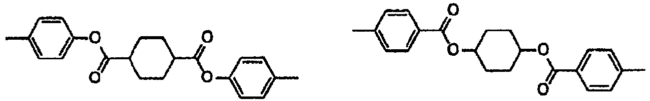

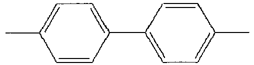

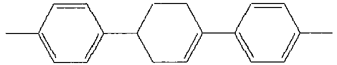

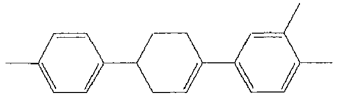

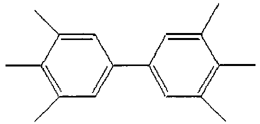

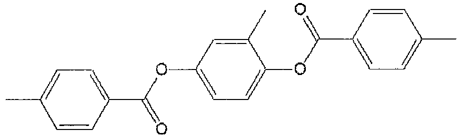

The compound represented by Formula (XXI) can be synthesized with reference to the method disclosed in JP1999-513019A (JP-H11-513019A) (WO97/000600A).

The rod-like compound may be a monomer having the mesogenic group disclosed in JP1999-323162A (JP-H11-323162A) and JP4118691B.

### [Suitable aspects in case where curing agent is disk-like compound and case where main agent is disk-like compound]

In a case where the curing agent is the disk-like compound and a case where the main agent is the disk-like compound, from the viewpoint that thermal conductivity of the thermally conductive material is more excellent, as the disk-like compound, a disk-like compound including a partial structure represented by Formulae (CR1) to (CR16) shown below is preferable, and a disk-like compound including a partial structure represented by Formula (CR4) or Formula (CR16) is more preferable.

In Formulae (CR1) to (CR16), * represents a bonding site.

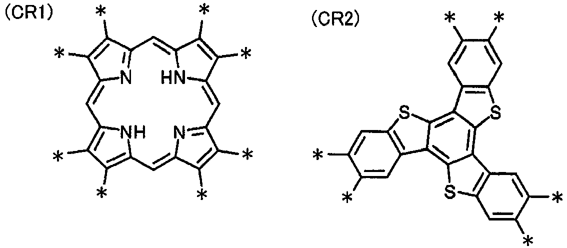

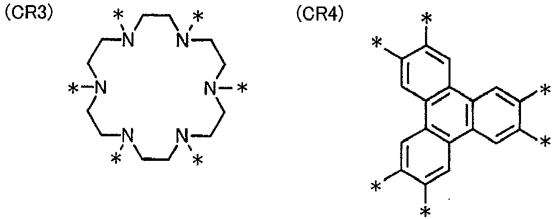

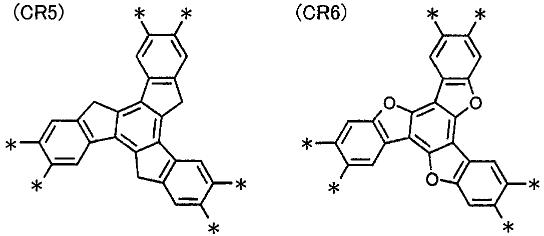

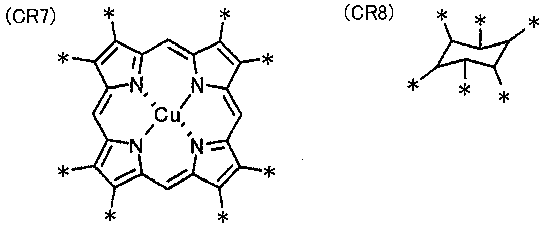

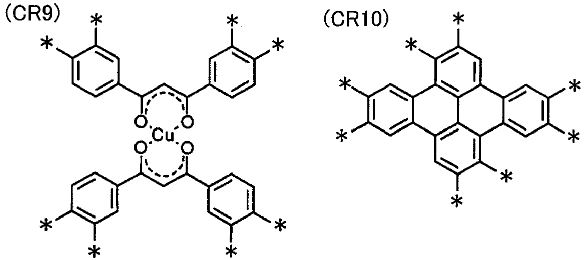

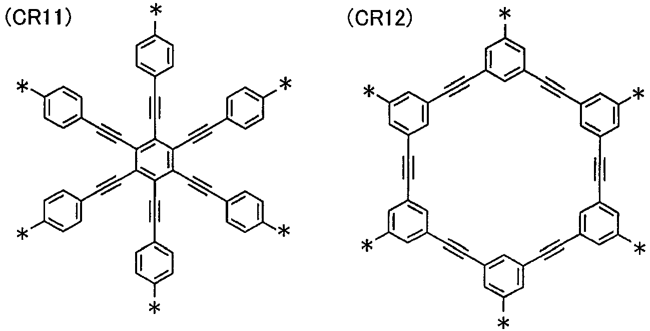

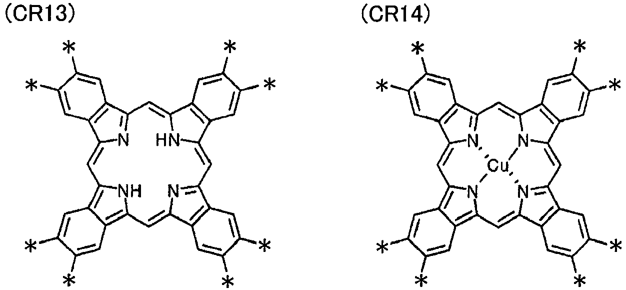

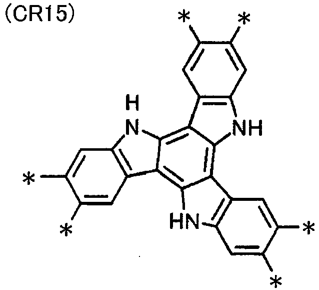

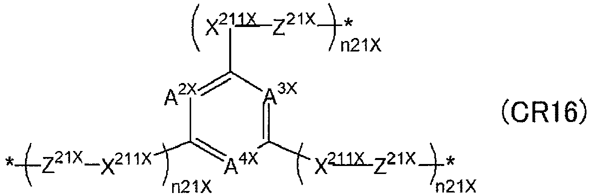

In Formula (CR16), a plurality of X^{211X'}s each independently represent a single bond, -O-, -C(=O)-, -NH-, -OC(=O)-, -OC(=O)O-, -OC(=O)NH-, -OC(=O)S-, -C(=O)O-, -C(=O)NH-, -C(=O)S-, -NHC(=O)-, -NHC(=O)O-, -NHC(=O)NH-, -NHC(=O)S-, -S-, -SC(=O)-, -SC(=O)O-, -SC(=O)NH-, or -SC(=O)S-.

A plurality of Z^{21X}'s each independently represent a 5-membered or 6-membered aromatic ring group or a 5-membered or 6-membered non-aromatic ring group.

A^{2X}, A^{3X}, and A^{4X} each independently represent -CH= or -N=, and it is preferable that all of A^{2X}, A^{3x}, and A^{4X} represent -CH=.

A plurality of n21X's each independently represent an integer of 0 to 3, and preferably represent an integer of 1 to 3.

Among these, as the disk-like compound, from the viewpoint that thermal conductivity of the thermally conductive material is more excellent, a compound represented by any of Formulae (D1) to (D16) is more preferable. Formulae (D1) to (D16) respectively correspond to the disk-like compound including Formulae (CR1) to (CR16) as a partial structure. In the following formulae, "-LQ" represents "-L-Q" and "QL-" represents "Q-L-".

Hereinafter, Formulae (D1) to (D15) will be described first.

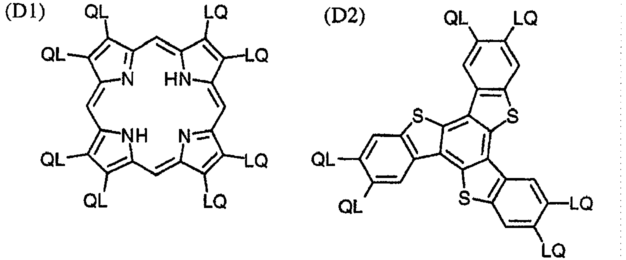

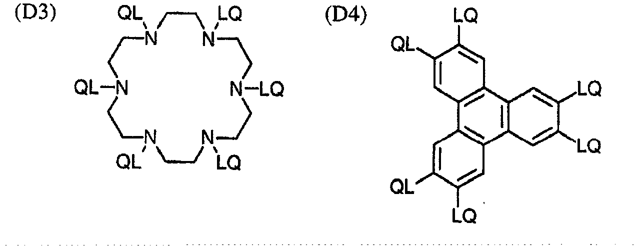

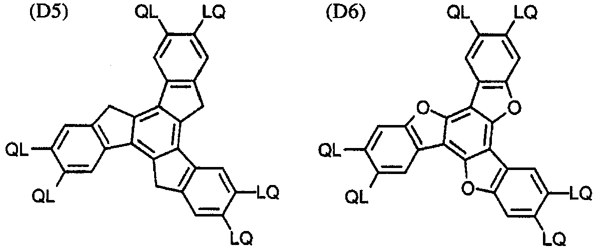

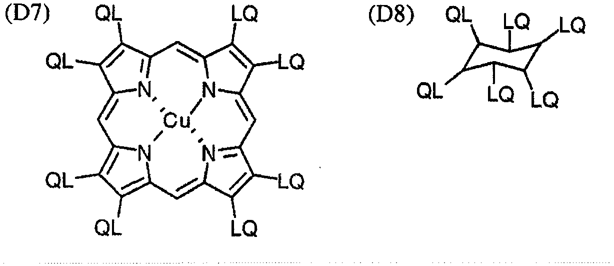

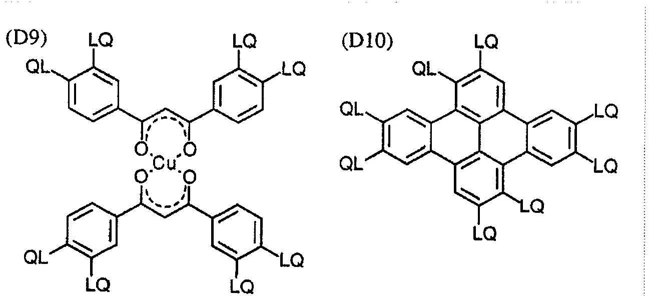

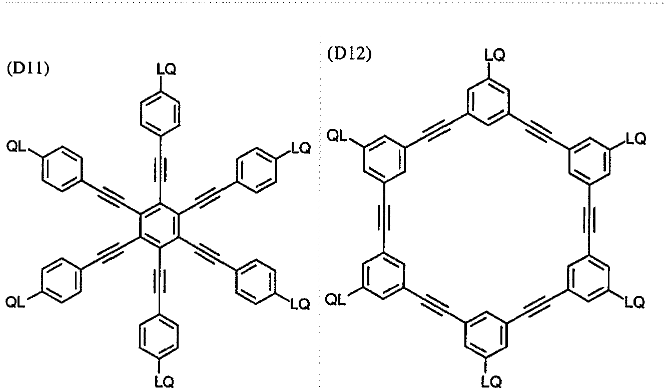

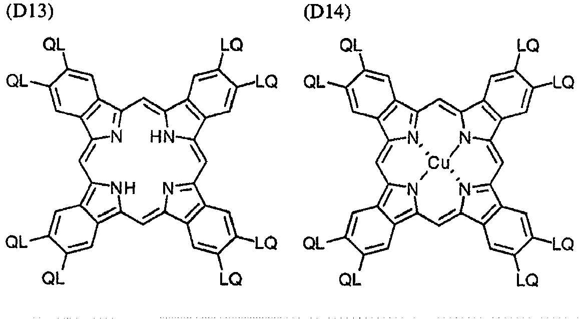

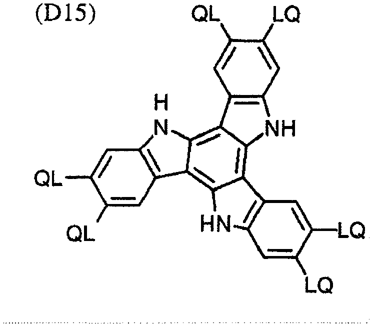

In Formulae (D1) to (D15), L represents a divalent linking group.

For the viewpoint that thermal conductivity of the thermally conductive material is more excellent, it is preferable that each L independently is a group selected from the group consisting of an alkylene group, an alkenylene group, an arylene group, -C(=O)-, -NH-, -O-, -S-, and a combination of these groups, and it is more preferable that each L independently is a group obtained by combining two or more groups selected from the group consisting of an alkylene group, an alkenylene group, an arylene group, -C(=O)-, -NH-, -O-, and -S-. As L, a divalent linking group including at least one of -C(=O)-O- or -O-C(=O)-.

The alkylene group preferably has 1 to 12 carbon atoms. The alkenylene group preferably has 2 to 12 carbon atoms. The arylene group preferably has 10 or less carbon atoms. The alkylene group, the alkenylene group, and the arylene group may have a substituent. The substituent is not particularly limited, and examples thereof include an alkyl group (preferably having 1 to 6 carbon atoms), a halogen atom, a cyano group, an alkoxy group (preferably having 1 to 6 carbon atoms), and an acyloxy group (preferably having 1 to 6 carbon atoms).

Examples of L are shown below. In the following examples, a bonding hand on the left side is bonded to the central nucleus (hereinafter, simply referred to as "central ring") of the compound represented by any of Formulae (D1) to (D15), and a bonding hand on the right side is bonded to Q.

AL represents an alkylene group or an alkenylene group, and AR represents an arylene group.
L101: -AL-C(=O)-O-AL-
L102: -AL-C(=O)-O-AL-O-
L103: -AL-C(=O)-O-AL-O-AL-
L104: -C(=O)-AR-O-AL-
L105 :-C(=O)-AR-O-AL-O-
L106: -NH-AL-O-
L107: -AL-C(=O)-O-AL-AR-
L108: -AL-C(=O)-O-AR-
L109: -O-AL-NH-AR-
L110: -O-AL-O-C(=O)-NH-AL-
L111: -O-AL-S-AL-
L112: -O-C(=O)-AL-AR-O-AL-
L113: -O-C(=O)-AL-AR-O-AL-O-
L114: -O-C(=O)-AR-O-AL-C(=O)-
L115: -O-C(=O)-AR-O-AL-
L116: -O-C(=O)-AR-O-AL-O-
L117: -O-C(=O)-AR-O-AL-O-AL-
L118: -O-C(=O)-AR-O-AL-O-AL-O-
L119: -O-C(=O)-AR-O-AL-O-AL-O-AL-
L120: -O-C(=O)-AR-O-AL-O-AL-O-AL-O-
L121: -S-AL-
L122: -S-AL-O-
L123: -S-AL-S-AL-
L124: -S-AR-AL-
L125: -O-C(=O)-AL-
L126: -O-C(=O)-AL-O-
L127: -O-C(=O)-AR-O-AL-
L128: -O-C(=O)-AR-O-AL-O-C(=O)-AL-S-AR-
L129: -O-C(=O)-AL-S-AR-
L130: -O-C(=O)-AR-O-AL-O-C(=O)-AL-S-AL-
L131: -O-C(=O)-AL-S-AR-
L132: -O-AL-S-AR-
L133: -AL-C(=O)-O-AL-O-C(=O)-AL-S-AR-
L134: -AL-C(=O)-O-AL-O-C(=O)-AL-S-AL-
L135: -AL-C(=O)-O-AL-O-AR-
L136: -O-AL-O-C(=O)-AR-
L137: -O-C(=O)-AL-O-AR-
L138: -O-C(=O)-AR-O-AL-O-AR-

In Formulae (D1) to (D15), each Q independently represents a hydrogen atom or a substituent.

In a case where Formulae (D1) to (D15) are the curing agent, examples of the substituent include an active hydrogen-containing functional group and the group listed in the above-described substituent group Y, and among these, an active hydrogen-containing functional group is preferable. However, in Formulae (D1) to (D15), one or more Q's are active hydrogen-containing functional groups, and among these, from the viewpoint that thermal conductivity of the thermally conductive material is more excellent, it is preferable that three or more Q's are active hydrogen-containing functional groups and it is more preferable that all of Q's are active hydrogen-containing functional groups. The definition of the active hydrogen-containing functional group is as described above.

In a case where Formulae (D1) to (D15) are the main agent, examples of the substituent include a reactive group and the group listed in the above-described substituent group Y, and among these, a reactive group is preferable. However, in Formulae (D1) to (D15), one or more Q's are reactive groups, and among these, from the viewpoint that thermal conductivity of the thermally conductive material is more excellent, it is preferable that three or more Q's are reactive groups and it is more preferable that all of Q's are reactive groups. The definition of the reactive group is as described above.

Among the compounds represented by Formulae (D1) to (D15), from the viewpoint that thermal conductivity of the thermally conductive material is more excellent, the compound represented by Formula (D4) is preferable.

As the compound represented by Formula (D4), from the viewpoint that thermal conductivity of the thermally conductive material is more excellent, a compound represented by Formula (XI) is preferable.

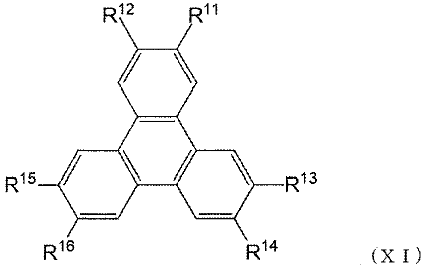

In Formula (XI), R¹¹, R¹², R¹³, R¹⁴, R¹⁵, and R¹⁶ each independently represent *-X¹¹-L¹¹-P¹¹ or *-X¹²-L¹²-Y¹².

* represents a bonding site with the triphenylene ring.

Among R¹¹, R¹², R¹³, R¹⁴, R¹⁵, and R¹⁶, two or more thereof are *-X¹¹-L¹¹-P¹¹, and it is preferable that three or more thereof are *-X¹¹-L¹¹-P¹¹.

Among these, from the viewpoint that thermal conductivity of the thermally conductive material is more excellent, it is preferable that any one or more of R¹¹ or R¹², any one or more of R¹³ or R¹⁴, and any one or more of R¹⁵ or R¹⁶ represent *-X¹¹-L¹¹-P¹¹ and it is more preferable that all of R¹¹, R¹², R¹³, R¹⁴, R¹⁵, and R¹⁶ represent *-X¹¹-L¹¹-P¹¹. It is still more preferable that all of R¹¹, R¹², R¹³, R¹⁴, R¹⁵, and R¹⁶ are the same.

Each X¹¹ independently represents a single bond, -O-, -C(=O)-, -NH-, -OC(=O)-, -OC(=O)O-, -OC(=O)NH-, -OC(=O)S-, -C(=O)O-, -C(=O)NH-, -C(=O)S-, -NHC(=O)-, -NHC(=O)O-, -NHC(=O)NH-, -NHC(=O)S-, -S-, -SC(=O)-, -SC(=O)O-, -SC(=O)NH-, or -SC(=O)S-.

Among these, each X¹¹ independently preferably represents -O-, -OC(=O)-, -OC(=O)O-, -OC(=O)NH-, -C(=O)O-, -C(=O)NH-, -NHC(=O)-, or -NHC(=O)O-, more preferably represents -O-, -OC(=O)-, -C(=O)O-, -OC(=O)NH-, or -C(=O)NH-, and still more preferably represent -C(=O)O-.

Each L¹¹ independently represents a single bond or a divalent linking group.

Examples of the divalent linking group include -O-, -OC(=O)-, -C(=O)O-, -S-, -NH-, an alkylene group (preferably having 1 to 10 carbon atoms, more preferably having 1 to 8 carbon atoms, still more preferably having 1 to 7 carbon atoms), an arylene group (preferably having 6 to 20 carbon atoms, more preferably having 6 to 14 carbon atoms, and still more preferably having 6 to 10 carbon atoms), and a group consisting of a combination of these groups.

Examples of the alkylene group include a methylene group, an ethylene group, a propylene group, a butylene group, a pentylene group, a hexylene group, and a heptylene group.

Examples of the arylene group include a 1,4-phenylene group, a 1,3-phenylene group, a 1,4-naphthylene group, a 1,5-naphthylene group, and an anthracenylene group. Among these, a 1,4-phenylene group is preferable.

Each of the alkylene group and the arylene group may have a substituent. The number of substituents is preferably 1 to 3 and more preferably 1. The substitution position of the substituent is not particularly limited. As the substituent, a halogen atom or an alkyl group having 1 to 3 carbon atoms is preferable, and a methyl group is more preferable.

It is also preferable that the alkylene group and the arylene group are unsubstituted. Among these, it is preferable that the alkylene group is unsubstituted.

-X¹¹-L¹¹- represents a divalent group.

Examples of -X¹¹-L¹¹- include L101 to L138 which are examples of L.

In a case where Formula (XI) is the curing agent, P¹¹ represents an active hydrogen-containing functional group. The definition of the active hydrogen-containing functional group is as described above. In a case where P¹¹ is a hydroxyl group, L¹¹ includes an arylene group, and it is preferable that the arylene group is bonded to P¹¹.

In a case where Formula (XI) is the main agent, P¹¹ represents a reactive group. The definition of the reactive group is as described above.

X¹² is the same as X¹¹, and suitable conditions are also the same.

L¹² is the same as L¹¹, and suitable conditions are also the same.

-X¹²-L¹²- represents a divalent group.

Examples of -X¹²-L¹²- include L101 to L138 which are examples of L.

Y¹² represents a hydrogen atom, a linear, branched, or cyclic alkyl group having 1 to 20 carbon atoms, or a group in which one methylene group or two or more methylene groups in a linear, branched, or cyclic alkyl group having 1 to 20 carbon atoms are substituted with -O-, -S-, -NH-, -N(CH₃)-, -C(=O)-, -OC(=O)-, or -C(=O)O-.

In a case where Y¹² represents a linear, branched, or cyclic alkyl group having 1 to 20 carbon atoms or a group in which one methylene group or two or more methylene groups in a linear, branched, or cyclic alkyl group having 1 to 20 carbon atoms are substituted with -O-, -S-, -NH-, -N(CH₃)-, -C(=O)-, -OC(=O)-, or -C(=O)O-, one or more hydrogen atoms included in Y¹² may be substituted with a halogen atom.

Y¹² is preferably a hydrogen atom, a linear, branched, or cyclic alkyl group having 1 to 20 carbon atoms, or a group in which one methylene group or two or more methylene groups in a linear, branched, or cyclic alkyl group having 1 to 20 carbon atoms are substituted with -O-, more preferably a linear or branched alkyl group having 1 to 12 carbon atoms, a group represented by -(OC₂H₄)ₘ₁-H having 2 to 20 carbon atoms (however, m1 represents an integer of 1 or more), or a group represented by -(OC₃H₆)ₘ₂-H having 3 to 20 carbon atoms (however, m2 represents an integer of 1 or more).

Regarding specific examples of the compound represented by Formula (XI), compounds disclosed in paragraphs 0028 to 0036 of JP1995-281028A (JP-H07-281028A), JP1995-306317A (JP-H07-306317A), paragraphs 0016 to 0018 of JP2005-156822A, paragraphs 0067 to 0072 of JP2006-301614A, and Liquid Crystal Handbook (published on 2000 from MARUZEN Co., Ltd.), pp. 330 to 333 can be referred to.

The compound represented by Formula (XI) can be synthesized based on the methods disclosed in JP1995-306317A (JP-H07-306317A), JP1995-281028A (JP-H07-281028A), JP2005-156822A, and JP2006-301614A.

Next, Formula (D16) will be described.

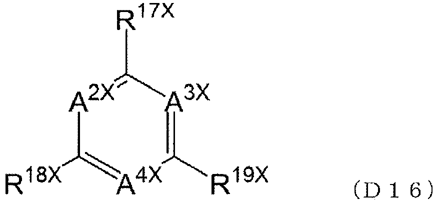

In Formula (D16), A^{2X}, A^{3x}, and A^{4X} each independently represent -CH= or -N=. Among these, it is preferable that all of A^{2X}, A^{3X}, and A^{4X} are -CH=. In other words, it is preferable that the central ring of the disk-like compound is a benzene ring.

R^{17X}, R^{18X}, and R^{19X} each independently represent *-(X^{211X}-Z^{21X})_{n21X}-L^{21X}-Q. * represents a bonding site to the central ring.

Each X^{211X} independently represents a single bond, -O-, -C(=O)-, -NH-, -OC(=O)-, -OC(=O)O-, -OC(=O)NH-, -OC(=O)S-, -C(=O)O-, -C(=O)NH-, -C(=O)S-, -NHC(=O)-, -NHC(=O)O-, -NHC(=O)NH-, -NHC(=O)S-, -S-, -SC(=O)-, -SC(=O)O-, -SC(=O)NH-, or -SC(=O)S-.

Each Z^{21X} independently represents a 5-membered or 6-membered aromatic ring group or a 5-membered or 6-membered non-aromatic ring group.

L^{21X} represents a single bond or a divalent linking group.

Q has the same meaning as Q in Formulae (D1) to (D15), and suitable aspects are also the same.

n21X represents an integer of 0 to 3. In a case where n21X is 2 or more, a plurality of (X^{211X}-Z^{21X}) may be the same as or different from each other.

As the compound represented by Formula (D16), a compound represented by Formula (XII) is preferable.

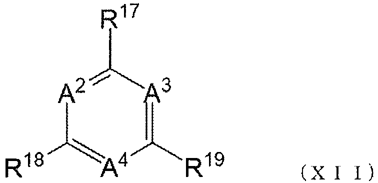

In Formula (XII), A², A³, and A⁴ each independently represent -CH= or -N=. Among these, it is preferable that all of A², A³, and A⁴ are -CH=. In other words, it is preferable that the central ring of the disk-like compound is a benzene ring.

R¹⁷, R¹⁸, and R¹⁹ each independently represent *-(X²¹¹-Z²¹)ₙ₂₁-L²¹-P²¹ or *-(X²²¹-Z²²)ₙ₂₂-Y²². * represents a bonding site to the central ring.

Among R¹⁷, R¹⁸, and R¹⁹, two or more thereof are *-(X²¹¹-Z²¹)ₙ₂₁-L²¹-P²¹. From the viewpoint that thermal conductivity of the thermally conductive material is more excellent, it is preferable that all of R¹⁷, R¹⁸, and R¹⁹ are *-(X²¹¹-Z²¹)ₙ₂₁-L²¹-P²¹. It is preferable that all of R¹⁷, R¹⁸, and R¹⁹ are the same.

X²¹¹ and X²²¹ each independently represent a single bond, -O-, -C(=O)-, -NH-, -OC(=O)-, -OC(=O)O-, -OC(=O)NH-, -OC(=O)S-, -C(=O)O-, -C(=O)NH-, -C(=O)S-, -NHC(=O)-, -NHC(=O)O-, -NHC(=O)NH-, -NHC(=O)S-, -S-, -SC(=O)-, -SC(=O)O-, -SC(=O)NH-, or -SC(=O)S-.

Among these, it is preferable that X²¹¹ and X²²¹ are each independently a single bond, -O-, -C(=O)O-, or -OC(=O)-.

Z²¹ and Z²² each independently represent a 5-membered or 6-membered aromatic ring group or a 5-membered or 6-membered non-aromatic ring group, and examples thereof include a 1,4-phenylene group, a 1,3-phenylene group, and an aromatic heterocyclic group.

The aromatic ring group and the non-aromatic ring group described above may have a substituent. The number of substituents is preferably 1 or 2 and more preferably 1. The substitution position of the substituent is not particularly limited. As the substituent, a halogen atom or a methyl group is preferable. It is also preferable that the aromatic ring group and the non-aromatic ring group are unsubstituted.

Examples of the aromatic heterocyclic group include the following aromatic heterocyclic groups.

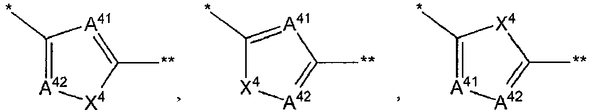

In the formulae, * represents a site bonded to X²¹¹ or X²²¹. ** represents a site bonded to L²¹ or Y²². A⁴¹ and A⁴² each independently represent a methine group or a nitrogen atom. X⁴ represents an oxygen atom, a sulfur atom, a methylene group, or an imino group.

It is preferable that at least one of A⁴¹ or A⁴² represents a nitrogen atom and it is more preferable that both of A⁴¹ and A⁴² represents a nitrogen atom. In addition, it is preferable that X⁴ represents an oxygen atom.

In a case where n21 and n22 described later are 2 or more, a plurality of (X²¹¹-Z²¹) and (X²²¹-Z²²) may be respectively the same as or different from each other.

Each L²¹ independently represents a single bond or a divalent linking group, and has the same meaning as L¹¹ in Formula (XI). As L²¹, -O-, -OC(=O)-, -C(=O)O-, -S-, -NH-, an alkylene group (preferably having 1 to 10 carbon atoms, more preferably having 1 to 8 carbon atoms, still more preferably having 1 to 7 carbon atoms), an arylene group (preferably having 6 to 20 carbon atoms, more preferably having 6 to 14 carbon atoms, and still more preferably having 6 to 10 carbon atoms), or a group consisting of a combination of these groups is preferable.

In a case where n21 described later is 1 or more, examples of -L²¹- include L101 to L138 which are examples of L in Formulae (D1) to (D15).

In a case where Formula (XII) is the curing agent, P²¹ represents an active hydrogen-containing functional group. The definition of the active hydrogen-containing functional group is as described above. In a case where P²¹ is a hydroxyl group, L²¹ includes an arylene group, and it is preferable that the arylene group is bonded to P²¹.

In a case where Formula (XII) is the main agent, P²¹ represents a reactive group. The definition of the reactive group is as described above.

Y²² represents a hydrogen atom, a linear, branched, or cyclic alkyl group having 1 to 20 carbon atoms, or a group in which one methylene group or two or more methylene groups in a linear, branched, or cyclic alkyl group having 1 to 20 carbon atoms are substituted with -O-, -S-, -NH-, -N(CH₃)-, -C(=O)-, -OC(=O)-, or -C(=O)O-. Suitable aspects of Y²² are the same as the suitable aspects of Y¹² in Formula (XI).

n21 and n22 each independently represent an integer of 0 to 3, and from the viewpoint that thermal conductivity is more excellent, are preferably an integer of 1 to 3, and are more preferably 2 or 3.

Preferred examples of the compound represented by Formula (XII) include the following compounds.

In the following structural formulae, R represents -L²¹-P²¹.

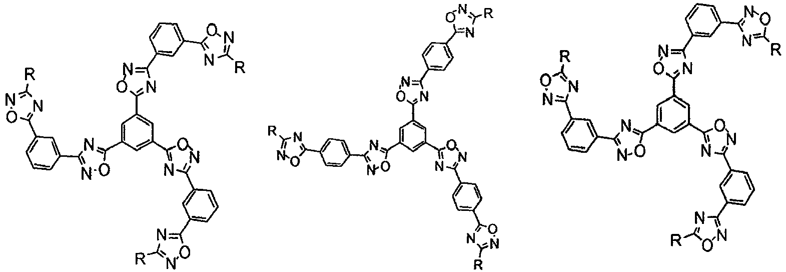

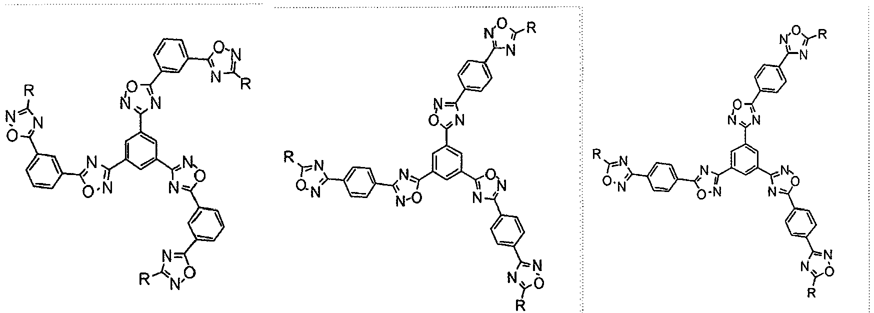

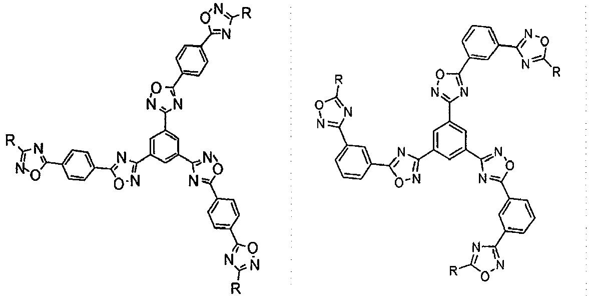

Regarding the details and specific examples of the compound represented by Formula (XII), the description in paragraphs 0013 to 0077 of JP2010-244038A can be referred to, and the contents thereof are incorporated into the present specification.

The compound represented by Formula (XII) can be synthesized based on the methods disclosed in JP2010-244038A, JP2006-076992A, and JP2007-002220A.

From the viewpoint that stacking is strengthened by reducing electron density and a columnar aggregate is easily formed, it is preferable that the disk-like compound is a compound having a hydrogen-bonding functional group. Examples of the hydrogen-bonding functional group include -OC(=O)NH-, -C(=O)NH-, -NHC(=O)-, -NHC(=O)O-, -NHC(=O)NH-, -NHC(=O)S-, and -SC(=O)NH-.

Hereinafter, specific examples of the curing agent will be described, but the curing agent is not limited thereto.

### (Curing agent)

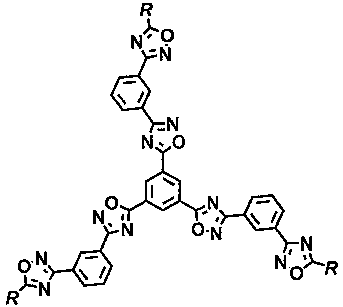

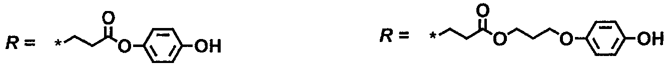

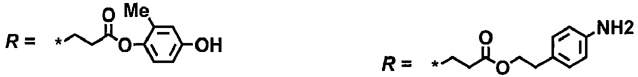

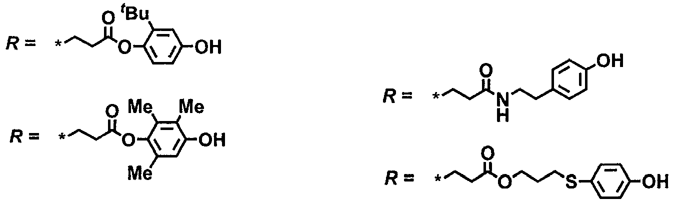

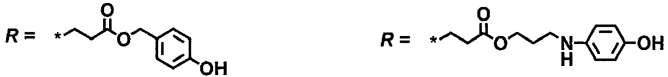

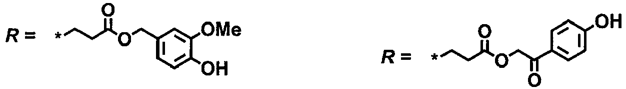

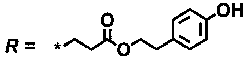

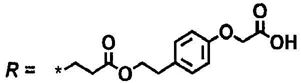

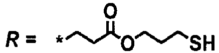

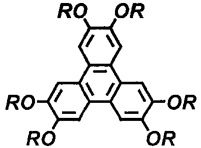

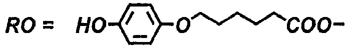

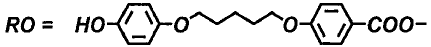

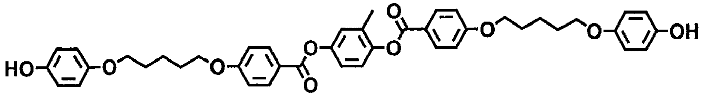

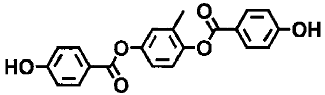

Hereinafter, specific examples of the main agent will be described, but the main agent is not limited thereto.

### (Main agent)

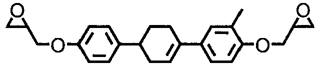

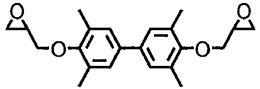

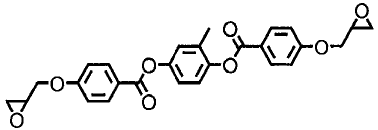

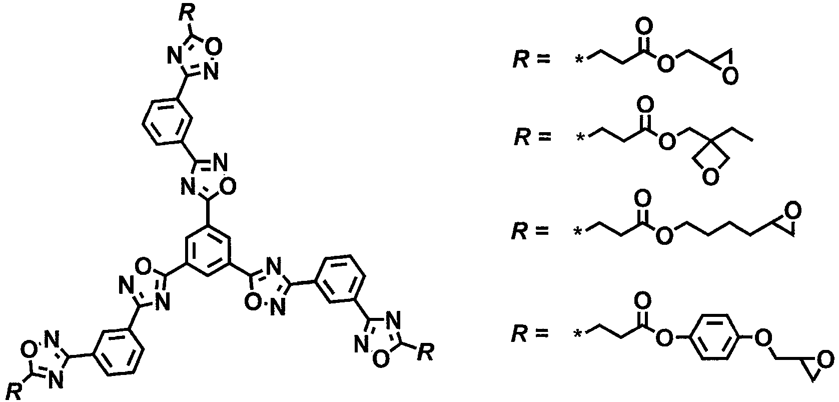

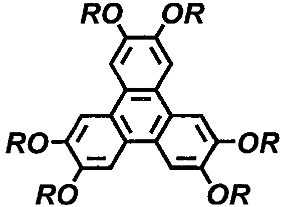

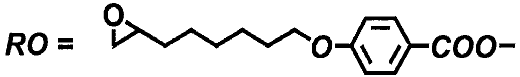

### [Other components]

The composition may include other components in addition to the curing agent and the main agent.

Hereinafter, other components which can be included in the composition according to the embodiment of the present invention will be described in detail.

### <Inorganic substance>

From the viewpoint that thermal conductivity of the obtained thermally conductive material is more excellent, it is preferable that the composition includes an inorganic substance.

As the inorganic substance, any inorganic substance used for a mineral filler of a thermally conductive material in the related art may be used. As the inorganic substance, an inorganic oxide or an inorganic nitride is preferable. The inorganic substance may be an inorganic oxynitride. The shape of the inorganic substance is not particularly limited, and the inorganic substance may have a granule shape, a film shape, or a plate shape. Examples of the shape of the granule shape inorganic substance include a rice-grain shape, a spherical shape, a cubical shape, a spindle shape, a scaly shape, an aggregated shape, and an amorphous shape.

Examples of the inorganic oxide include zirconium oxide (ZrO₂), titanium oxide (TiO₂), silicon oxide (SiO₂), aluminum oxide (Al₂O₃), iron oxide (Fe₂O₃, FeO, or Fe₃O₄), copper oxide (CuO or Cu₂O), zinc oxide (ZnO), yttrium oxide (Y₂O₃), niobium oxide (Nb₂O₅), molybdenum oxide (MoO₃), indium oxide (In₂O₃ or In₂O), tin oxide (SnO₂), tantalum oxide (Ta₂O₅), tungsten oxide (WO₃ or W₂O₅), lead oxide (PbO or PbO₂), bismuth oxide (Bi₂O₃), cerium oxide (CeO₂ or Ce₂O₃), antimony oxide (Sb₂O₃ or Sb₂O₅), germanium oxide (GeO₂ or GeO), lanthanum oxide (La₂O₃), and ruthenium oxide (RuO₂).

The inorganic oxide may be used singly or in combination of two or more thereof.

As the inorganic oxide, titanium oxide, aluminum oxide, or zinc oxide is preferable, and aluminum oxide is more preferable.

The inorganic oxide may be an oxide generated in a case where a metal prepared as a non-oxide is oxidized due to the environment or the like.

Examples of the inorganic nitride include boron nitride (BN), carbon nitride (C₃N₄), silicon nitride (Si₃N₄), gallium nitride (GaN), indium nitride (InN), aluminum nitride (AlN), chromium nitride (Cr₂N), copper nitride (Cu₃N), iron nitride (Fe₄N), iron nitride (Fe3N), lanthanum nitride (LaN), lithium nitride (Li₃N), magnesium nitride (Mg₃N₂), molybdenum nitride (Mo₂N), niobium nitride (NbN), tantalum nitride (TaN), titanium nitride (TiN), tungsten nitride (W₂N), tungsten nitride (WN₂), yttrium nitride (YN), and zirconium nitride (ZrN).

The inorganic nitride may be used singly or in combination of two or more thereof.

The inorganic nitride preferably includes an aluminum atom, a boron atom, or a silicon atom, and is more preferably aluminum nitride, boron nitride, or silicon nitride, still more preferably aluminum nitride or boron nitride, and particularly preferably boron nitride.

The size of the inorganic substance is not particularly limited, but from the viewpoint that dispersibility of the inorganic substance is more excellent, an average particle diameter of the inorganic substance is preferably 500 µm or less, more preferably 300 µm or less, and still more preferably 200 µm or less. The lower limit of the average particle diameter is not particularly limited, but from the viewpoint of handleability, is preferably 10 nm or more and more preferably 100 nm or more.

In a case of using a commercially available product, a catalog value is adopted as the average particle diameter of the inorganic substance. In a case where the catalog value is not present, as a method for measuring the average particle diameter, 100 inorganic substances are randomly selected using an electron microscope, particle diameters (major axises) of the inorganic substances are measured, and the arithmetic mean thereof is calculated.

The inorganic substance may be used singly or in combination of two or more thereof.

In a case where the composition includes the inorganic substance, the content of the inorganic substance in the composition is preferably 1% to 90% by mass, more preferably 5% to 90% by mass, and still more preferably 10% to 90% by mass with respect to the total solid content of the composition.

In a case where the composition includes the inorganic substance, from the viewpoint that thermal conductivity of the thermally conductive material is more excellent, it is more preferable that the composition includes at least inorganic particles having an average particle diameter of 20 µm or more (preferably, 50 µm or more).

In addition, in a case where the composition includes the inorganic substance, from the viewpoint that thermal conductivity of the thermally conductive material is more excellent, it is more preferable that the composition includes boron nitride.

### <Curing accelerator>

The composition may further include a curing accelerator.

The type of the curing accelerator is not limited, and examples thereof include triphenylphosphine, 2-ethyl-4-methylimidazole, a boron trifluoride amine complex, 1-benzyl-2-methylimidazole, and the compound disclosed in paragraph 0052 of JP2012-067225A.

In a case where the composition includes the curing accelerator, the content of the curing accelerator in the composition is not particularly limited, but is preferably 0.1% to 20% by mass with respect to the total solid content in the composition.

### <Polymerization initiator>

The composition may further include a polymerization initiator.

In particular, in a case where the main agent has a (meth)acryloyl group as the reactive group, it is preferable that the composition includes polymerization initiators disclosed in paragraph 0062 of JP2010-125782A and paragraph 0054 of JP2015-052710A.

In a case where the composition includes the polymerization initiator, the content of the polymerization initiator in the composition is not particularly limited, but is preferably 0.1% to 50% by mass with respect to the total solid content in the composition.

### <Solvent>

The composition may further include a solvent.

The type of the solvent is not particularly limited, but the solvent is preferably an organic solvent. Examples of the organic solvent include ethyl acetate, methyl ethyl ketone, dichloromethane, and tetrahydrofuran.

### [Method for manufacturing composition]

The method for manufacturing the composition is not particularly limited, and known methods can be adopted. For example, the composition can be manufactured by mixing the above-described various components by a known method. At the time of mixing, the various components may be mixed at a time or mixed sequentially.

It is preferable that the composition according to the embodiment of the present invention exhibits nematic liquid crystallinity. In a case where the main agent and the curing agent each independently exhibit nematic liquid crystallinity, a composition including both generally also exhibits nematic liquid crystallinity. Among these, it is preferable that the composition according to the embodiment of the present invention has a phase transition temperature of crystal phase to liquid crystal phase of 130°C or lower, and it is more preferable that the composition according to the embodiment of the present invention has a phase transition temperature of crystal phase to liquid crystal phase of 130°C or lower and a phase transition temperature of isotropic phase to liquid crystal phase of 250°C or lower.

### [Method for manufacturing thermally conductive material (method for curing composition)]

Hereinafter, the method for manufacturing a thermally conductive material according to an embodiment of the present invention will be described.

The method for manufacturing a thermally conductive material according to the embodiment of the present invention includes at least the following steps 1 to 3.

### Step 1: step of forming a composition layer using the composition.

Step 2: step of heating the composition layer to a temperature of 150°C or lower, at which both of the curing agent and the main agent exhibits liquid crystallinity, to align the curing agent and the main agent.

Step 3: step of curing the composition layer.

Hereinafter, the steps 1 to 3 will be described in detail.

### <Step 1>

The step 1 is a step of forming a composition layer using the composition according to the embodiment of the present invention. Specifically, the step 1 is a step of applying the above-described composition on a substrate and forming a composition layer.

### (Substrate)

The substrate is a plate which supports the layer of the composition described later. The substrate is usually separated from the composition layer after curing the composition layer.

A material constituting the substrate is not particularly limited, and examples thereof a plastic film, a metal film, and a glass plate.

Examples of a material of the plastic film include polyesters such as polyethylene terephthalate (PET), polycarbonates, acrylic resins, epoxy resins, polyurethanes, polyamides, polyolefins, cellulose derivatives, and silicone.

Examples of the metal film include a copper film.

The thickness of the substrate is not particularly limited, but from the viewpoint of thinning and handleability, and is preferably 5 to 2000 µm and more preferably 10 to 1000 µm.

The thickness means an average thickness, and is obtained by measuring thicknesses of any 5 points on the substrate and arithmetically averaging them. Regarding the method for measuring the thickness, the same applies to the thickness of the reflective layer described later.

### (Procedure of step 1)

In the step 1, first, the above-described composition is applied on the substrate. The application method is not particularly limited, and examples thereof include a wire bar coating method, an extrusion coating method, a direct gravure coating method, a reverse gravure coating method, and a die-coating method.

After the application, the composition applied on the substrate may be subjected to a drying treatment as necessary. By performing the drying treatment, the solvent can be removed from the applied composition.

The film thickness of the composition (composition layer) applied on the substrate is not particularly limited, but is preferably 5 to 2000 µm, more preferably 10 to 1000 µm, and still more preferably 20 to 1000 µm.

### <Step 2>

The step 2 is a step of aligning a liquid crystal compound (the main agent and the curing agent) included in the composition layer obtained through the step 1 to obtain a liquid crystal phase. Through the step 2, a thermally conductive material in which nematic liquid crystal phase is fixed can be obtained.

Examples of the method for aligning the main agent and the curing agent include a method for heating the composition layer. Specifically, the composition (composition layer) applied on the substrate is heated and the main agent and the curing agent in the composition layer are aligned to obtain a liquid crystal phase.

The heating temperature of the composition layer is not particularly limited as long as a temperature at which each of the curing agent and the main agent exhibits liquid crystallinity (preferably nematic liquid crystallinity) and a temperature of 150°C or lower. In a case where the heating temperature of the composition layer is 150°C or lower, the curing reaction of the curing agent and the main agent does not substantially proceed in many cases. The heating time is, for example, 30 minutes to 12 hours.

In addition, from the viewpoint that thermal conductivity of the thermally conductive material is more excellent, a difference {(heating temperature in step 3 (heating temperature of main curing)) - (heating temperature in step 2)} of the heating temperature in the step 2 and the heating temperature in the step 3 (heating temperature of main curing) described later is preferably 10°C to 150°C, more preferably 20°C to 120°C, and still more preferably 20°C to 100°C.

In addition, from the viewpoint that thermal conductivity of the thermally conductive material is more excellent, the heating temperature in the step 2 and a temperature {(temperature at which curing reaction of curing agent and main agent substantially starts in step 3) - (heating temperature in step 2)} at which the curing reaction of the curing agent and the main agent substantially starts in the step 3 is preferably 10°C to 150°C, more preferably 20°C to 120°C, and still more preferably 20°C to 100°C. In a case where the step 3 includes a semi-curing reaction, the heating temperature during the semi-curing reaction corresponds to the temperature at which the curing reaction of the curing agent and the main agent substantially starts in the step 3.

### <Step 3>

The step 3 is a step of curing the composition layer by reacting the curing agent with the main agent. The curing reaction is preferably performed on the composition formed into a sheet. At this time, press working may also be performed.

In addition, the curing reaction may be a semi-curing reaction. That is, the obtained cured product may be in a so-called B stage state (semi-cured state).

In a case of disposing the semi-cured product so as to contact with a device or the like and performing main curing by heating or the like on the semi-cured product, adhesiveness between a layer including a thermally conductive material, which is a cured product, and the device is further improved.

The curing method is not particularly limited, and an optimal method is appropriately selected according to the types of the active hydrogen-containing functional group included in the curing agent and the reactive group included in the main agent. The curing method may be, for example, a thermosetting reaction or a photocuring reaction, but from the viewpoint that thermal conductivity of the thermally conductive material is more excellent, a thermosetting reaction is preferable.

The heating temperature during the thermosetting reaction is not particularly limited, but for example, is preferably in a temperature range of 150°C to 250°C and more preferably in a temperature range of 150°C to 200°C. In addition, during performing the thermosetting reaction, a heating treatment may be performed multiple times at different temperatures.

In addition, in a case of performing the photocuring reaction, it is more preferable that the photocuring reaction is a radical polymerization reaction by ultraviolet irradiation.

A light source such as an ultraviolet lamp is used for ultraviolet irradiation.

The irradiation energy amount of the ultraviolet rays is not particularly limited, but generally, is preferably approximately 0.1 to 0.8 J/cm². In addition, the time for irradiating ultraviolet rays is not particularly limited, but may be appropriately determined from the viewpoint of both of the sufficient strength and productivity of the obtained layer.

### [Use]

The composition can be applied to various fields as a thermally conductive material. The shape of the thermally conductive material is not particularly limited, and may be, for example, a sheet.

Hereinafter, the thermally conductive material will be described in detail.

### (Thermally conductive material)

The thermally conductive material can be formed by using the above-described composition. That is, the composition can be used for forming the thermally conductive material.

The thermally conductive material is a material having excellent thermal conductivity, and can be used as a heat dissipation material such as a heat dissipation sheet. For example, the thermally conductive material can be used for dissipating heat from various devices such as power semiconductor devices. More specifically, in a case of producing a device with a thermally conductive layer by disposing a thermally conductive layer including the thermally conductive material on a device, the heat generated from the device can be efficiently dissipated by the thermally conductive layer.

The shape of the thermally conductive material is not particularly limited, and may be formed into various shapes depending on the use. Typically, the thermally conductive material is preferably in the form of a sheet.

The thermally conductive material may be in a completely cured state or a semi-cured state (B stage state described above). As described above, since the thermally conductive material has sufficient thermal conductivity even in the semi-cured state, the thermally conductive material can also be used as a heat dissipation material disposed at a location where light for photocuring is difficult to reach, such as a gap between members of various devices. In addition, the thermally conductive material can also be used as an adhesive having thermal conductivity.

The thermally conductive material may be used in combination with another member. Specifically, for example, in a case where the thermally conductive material is in a form of a sheet, the thermally conductive material in the form of a sheet may be laminated on a support in the form of a sheet. In a case of laminating the thermally conductive material in the form of a sheet, as the sheet, the substrate (substrate used in the step 1) used during manufacturing may be used as it is.

### Examples

Hereinafter, the present invention will be described in more detail based on examples. The material, the amount to be used, the proportion, the details of treatments, the procedure of treatments, and the like shown in the following examples can be appropriately changed within a range which does not depart from the gist of the present invention. Accordingly, the scope of the present invention is not construed as being limited to the following examples.

### [Preparation and evaluation of composition]

### [Various components]

Hereinafter, various components used in examples and comparative examples will be shown.

### <Curing agent>

Curing agents used in examples and comparative examples will be shown below. In the structural formula, * indicates a bonding site.

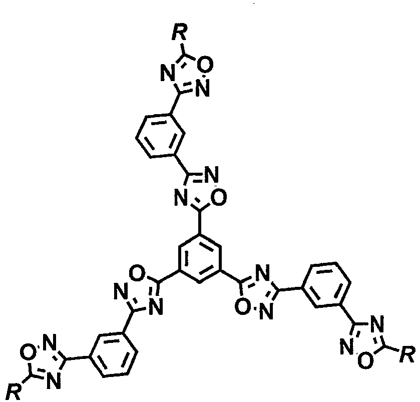

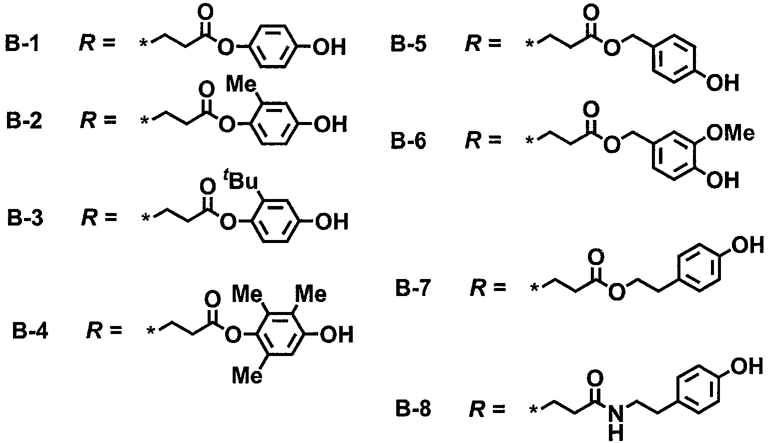

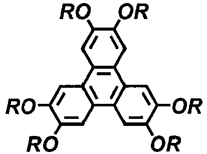

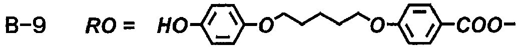

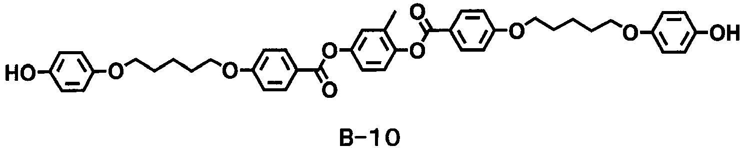

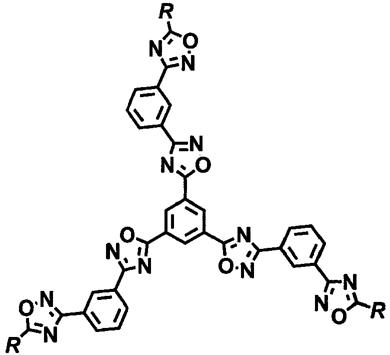

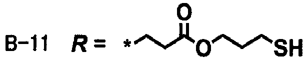

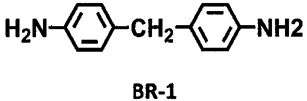

### KAYAHARD GPH-65

### manufactured by Nippon Kayaku Co., Ltd.

### BR-2

### <Main agent>

Main agents used in examples and comparative examples will be shown below. In the structural formula, * indicates a bonding site.

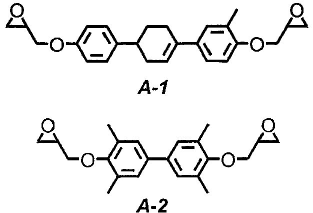

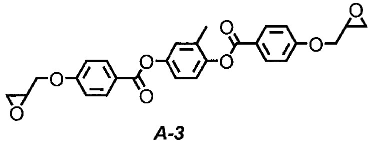

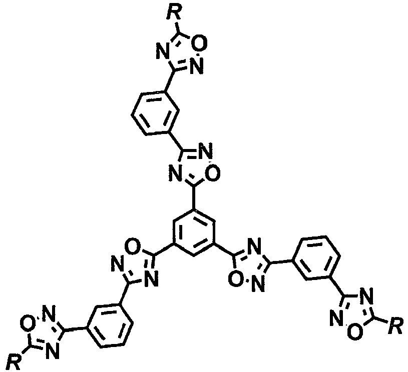

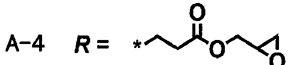

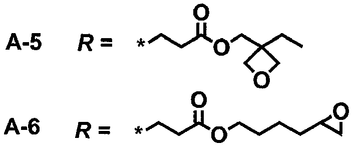

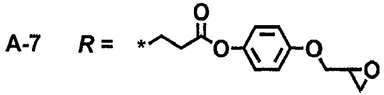

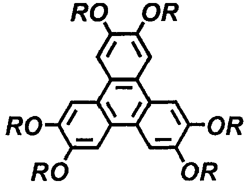

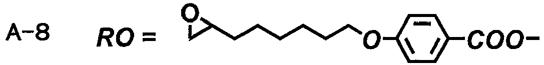

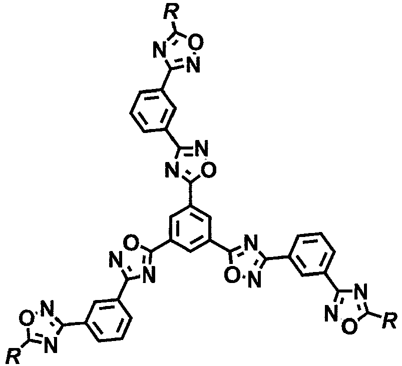

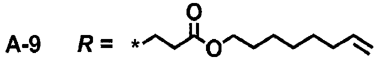

### <Inorganic substance>

Inorganic substances used in examples and comparative examples will be shown below.
"PTX-60": aggregated boron nitride (average particle diameter: 60 µm, manufactured by MOMENTIVE)
"PT-110": plate-like boron nitride (average particle diameter: 45 µm, manufactured by MOMENTIVE)
"S-50": aluminum nitride (average particle diameter: 55 µm, manufactured by MARUWA)
"SGPS": boron nitride (average particle diameter: 12 µm, manufactured by Denka Company Limited.)
"AA-3": alumina (average particle diameter: 3 µm, manufactured by Sumitomo Chemical Co., Ltd.)
"AA-04": alumina (average particle diameter: 0.4 µm, manufactured by Sumitomo Chemical Co., Ltd.)

### <Solvent>

As a solvent, tetrahydrofuran (THF) or methyl ethyl ketone (MEK) was used.

### <Curing accelerator>

As a curing accelerator, triphenylphosphine (PPh₃) was used.

### [Liquid crystallinity of curing agent and main agent]

Each compound of the curing agents and the main agents was heated on a hot stage in a single state. After heating, the compound was observed by a polarizing microscope while cooling to examine liquid crystallinity at 150°C or lower.

Tables 1 and 2 show the presence or absence of liquid crystallinity at 150°C or lower of each compound of the curing agents and the main agents, and the types of liquid crystal phase. In Tables 1 and 2, "-" means that no liquid crystallinity was exhibited. In addition, in Tables 1 and 2, "D_{Ne}" means discotic nematic phase and "Ne" means nematic phase.

The main agent (compound A-4) used in Example 8 was K80/D_{Ne}230/Iso, and the curing agent (compound B-4) used in Example 8 was K148/D_{Ne}185/Iso.

In a case where liquid crystallinity of a composition prepared in Example 8 was examined based on the same method as the method of Example 1 described later, the composition was K130/D_{Ne}200/Iso.

Furthermore, the main agent (compound A-4) used in Example 11 was K80/D_{Ne}230/Iso, and the curing agent (compound B-7) used in Example 11 was K72/D_{Ne}147/Iso.

In addition, in a case where liquid crystallinity of a composition prepared in Example 11 was examined based on the same method as the method of Example 1 described later, the composition was K67/D_{Ne}191/Iso.

### [Example 1]

Based on the formulation shown in Table 1, the main agent and the curing agent were dissolved in THF to obtain a solution. Next, the solution was added dropwise to hexane stirred. Thereafter, a mixed powder composition 1 of the main agent and the curing agent was obtained by filtration.

Next, the composition 1 was uniformly placed on a release surface of a polyester film (NP-100A, manufactured by PANAC Corporation, film thickness: 100 µm) was treated at 15 MPa for 2 minutes under air.

Next, an opposite surface of the treated surface of the polyester film with the composition 1 was covered with another polyester film, and was treated with a hot press under air (treated at a hot plate temperature of 80°C to 150°C (since liquid crystallinity differs according to a compound used, the hot plate temperature was appropriately adjusted according to the compound) and a pressure of 12 MPa for 30 minutes, treated at a temperature of 170°C and a pressure of 12 MPa for 30 minutes, and then treated at a temperature of 190°C for 2 hours) to cure the composition 1 and obtain a resin sheet. The polyester film on both surfaces of the resin sheet was peeled off, thereby obtaining a thermally conductive sheet 1 having an average film thickness of 150 µm.

In Example 11, by treating at a hot plate temperature of 80°C and a pressure of 12 MPa for 30 minutes as the above-described step 2, and then treating at a temperature of 170°C and a pressure of 12 MPa for 30 minutes (semi-curing reaction) and treating at a temperature of 190°C for 2 hours (main curing) as the above-described step 3, the composition 1 was cured.

### <Liquid crystallinity of composition 1>

The composition 1 was heated on a hot stage. After heating, the composition was observed by a polarizing microscope while cooling to examine liquid crystallinity at 150°C or lower.

Table 1 shows the presence or absence of liquid crystallinity at 150°C or lower of the composition, and the types of liquid crystal phase.

### <Evaluation of thermal conductivity>

Thermal conductivity was evaluated using the thermally conductive sheet 1. The thermal conductivity was measured by the following method and evaluated based on the following standards.

### (Measurement of thermal conductivity (W/m×k))

(1) By using "ai-Phase Mobile 1u" manufactured by ai-Phase Co., Ltd., a coefficient of thermal diffusivity of the thermally conductive sheet 1 in a thickness direction was measured.
(2) By using a balance "XS204" manufactured by METTLER TOLEDO, the specific gravity of the thermally conductive sheet 1 was measured by the Archimedes method ("solid specific gravity measuring kit" was used).
(3) By using "DSC320/6200" manufactured by Seiko Instruments Inc., the specific heat of the thermally conductive sheet 1 at 25°C was measured under the heating condition of 10°C/min.
(4) The obtained coefficient of thermal diffusivity was multiplied by the specific gravity and the specific heat, thereby calculating the thermal conductivity of the thermally conductive sheet 1.

### (Evaluation standard)

"A": 0.7 W/m×K or more
"B": 0.5 W/m×K or more and less than 0.7 W/m×K
"C": 0.3 W/m×K or more and less than 0.5 W/m×K
"D": less than 0.3 W/m×K

The results are shown in Table 1.

### [Examples 2 to 20 and Comparative Examples 1 and 2]

Based on the formulations shown in Table 1, each composition of examples and comparative examples were obtained according to the same procedure as in Example 1.

In addition, liquid crystallinity at 150°C or lower was evaluated for each of the obtained compositions in the same manner as in Example 1. Furthermore, from the obtained compositions, thermally conductive sheets 2 to 20 and comparative thermally conductive sheets 1 and 2 were produced, and these were subjected to the same evaluation test of thermal conductivity as in Example 1. The results are shown in Table 1.

Table 1 is shown below.

In Table 1 and Table 2 described later, (numerical value) described in the column of components of each composition means the content (% by mass) of each component with respect to the total solid content of the composition.

In addition, "Film thickness [µm]" described in Table 1 and Table 2 described later means the average film thickness of the thermally conductive sheet.

"Molecular shape" described in Table 1 and Table 2 described later indicates whether the main agent and curing agent used are a disk-like compound or a rod-like compound.

"Molecular structure of disk-like compound" described in Table 1 and Table 2 described later indicates whether, in a case where the main agent and curing agent used is a disk-like compound, a partial structure thereof corresponds to Formula (CR4) or Formula (CR16).

"Liquid crystallinity at 150°C or lower" described in the column of the main agent and curing agent in Table 1 and Table 2 described later means the presence or absence of liquid crystallinity of each compound of the main agent and the curing agent in a single state at 150°C or lower. In Table 1, "-" means that no liquid crystallinity was exhibited at 150°C or lower. In addition, in Table 1 and Table 2 described later, "D_{Ne}" means discotic nematic phase, "Ne" means nematic phase, "Sm" means smectic liquid crystal phase.

**[Table 1]**

| Table 1 (not containing inorganic substance) | Composition of composition | | | | | | | | | | Liquid crystallinity of composition at temperature of 150°C or less | Evaluation result | |
|---|---|---|---|---|---|---|---|---|---|---|---|---|---|
| | Curing agent | | | | | Main agent | | | | | | Thermal conductivity | Film thickness [µm] |
| | Type | | | | Content (% by mass) | Type | | | | Content (% by mass) | | | |
| | Compound | Molecular shape | Partial structure of disk-like compound | Liquid crystallinity at temperature of 150°C or less | | Compound | Molecular shape | Partial structure of disk-like compound | Liquid crystallinity at temperature of 150°C or less | | | | |
| Example 1 | B-9 | Disk-like | CR4 | D_{Nc} | 50 | A-8 | Disk-like | CR4 | D_{Nc} | 50 | D_{Nc} | A | 150 |
| Example 2 | B-1 | Disk-like | CR16 | D_{Nc} | 50 | A-4 | Disk-like | CR16 | D_{Nc} | 50 | D_{Nc} | A | 150 |
| Example 3 | B-1 | Disk-like | CR16 | D_{Nc} | 50 | A-5 | Disk-like | CR16 | D_{Nc} | 50 | D_{Nc} | A | 150 |
| Example 4 | B-1 | Disk-like | CR16 | D_{Nc} | 50 | A-6 | Disk-like | CR16 | D_{Nc} | 50 | D_{Nc} | A | 150 |
| Example 5 | B-1 | Disk-like | CR16 | D_{Nc} | 50 | A-7 | Disk-like | CR16 | D_{Nc} | 50 | D_{Nc} | A | 150 |
| Example 6 | B-2 | Disk-like | CR16 | D_{Nc} | 50 | A-4 | Disk-like | CR16 | D_{Nc} | 50 | D_{Nc} | A | 150 |
| Example 7 | B-3 | Disk-like | CR16 | D_{Nc} | 50 | A-4 | Disk-like | CR16 | D_{Nc} | 50 | D_{Nc} | A | 150 |
| Example 8 | B-4 | Disk-like | CR16 | D_{Nc} | 50 | A-4 | Disk-like | CR16 | D_{Nc} | 50 | D_{Nc} | A | 150 |
| Example 9 | B-5 | Disk-like | CR16 | D_{Nc} | 50 | A-4 | Disk-like | CR16 | D_{Nc} | 50 | D_{Nc} | A | 150 |
| Example 10 | B-6 | Disk-like | CR16 | D_{Nc} | 50 | A-4 | Disk-like | CR16 | D_{Nc} | 50 | D_{Nc} | A | 150 |
| Example 11 | B-7 | Disk-like | CR16 | D_{Nc} | 50 | A-4 | Disk-like | CR16 | D_{Nc} | 50 | D_{Nc} | A | 150 |
| Example 12 | B-10 | Rod-like | - | Ne | 56 | A-1 | Rod-like | - | Ne | 44 | Ne | C | 150 |
| Example 13 | B-10 | Rod-like | - | Ne | 60 | A-3 | Rod-like | - | Ne | 40 | Ne | C | 150 |
| Example 14 | B-7 | Disk-like | CR16 | D_{Nc} | 50 | A-8 | Disk-like | CR4 | D_{Nc} | 50 | D_{Nc} | B | 150 |
| Example 15 | B-3 | Disk-like | CR16 | D_{Nc} | 50 | A-8 | Disk-like | CR4 | D_{Nc} | 50 | D_{Nc} | B | 150 |
| Example 16 | B-9 | Disk-like | CR4 | D_{Nc} | 50 | A-8 | Disk-like | CR4 | D_{Nc} | 50 | D_{Nc} | A | 150 |
| Example 17 | B-8 | Disk-like | CR16 | D_{Nc} | 50 | A-4 | Disk-like | CR16 | D_{Nc} | 50 | D_{Nc} | A | 150 |
| Example 18 | B-11 | Disk-like | CR16 | D_{Nc} | 50 | A-9 | Disk-like | CR16 | D_{Nc} | 50 | D_{Nc} | B | 150 |
| Example 19 | B-1 | Disk-like | CR16 | D_{Nc} | 60 | A-3 | Rod-like | - | Ne | 40 | Ne | C | 150 |
| Example 20 | B-10 | Rod-like | - | Ne | 40 | A-4 | Disk-like | CR16 | D_{Nc} | 60 | D_{Nc} | C | 150 |
| Comparative Example 1 | BR-1 | Rod-like | - | - | 50 | A-1 | Rod-like | - | Sm | 50 | - | D | 150 |
| Comparative Example 2 | BR-2 | Rod-like | - | - | 50 | A-2 | Rod-like | - | - | 50 | - | D | 150 |

From the results in Table 1, according to the compositions of examples, it was clear that thermally conductive materials having excellent thermal conductivity can be formed.

In addition, from the results in Table 1, in a case where both of the curing agent and the main agent is a disk-like compound, it was confirmed that thermal conductivity is more excellent (refer to results of Example 12, Example 13, Example 19, and Example 20).

In addition, from the results in Table 1, in a case where both of the curing agent and the main agent is a disk-like compound having a partial structure represented by Formula (CR4) or a disk-like compound having a partial structure represented by Formula (CR16), it was confirmed that thermal conductivity is more excellent (refer to results of Example 14 and Example 15).

In addition, from the result in Table 1, in a case where the main agent includes a ring-polymerizable group, it was confirmed that thermal conductivity is more excellent (refer to result of Example 18).

On the other hand, none of the thermally conductive materials obtained from the compositions of comparative examples satisfied desired requirements.

### [Example 21]

Various components shown in Table 2 were mixed in order of a main agent, methyl ethyl ketone (MEK), and a curing agent, and then an inorganic substance was added thereto. The obtained mixture was treated for 5 minutes by using a planetary centrifugal mixer (manufactured by THINKY Corporation, AWATORI RENTARO ARE-310) to obtain a composition 21.

In addition, the final solid content of the composition 21 was adjusted using MEK so as to be the concentration of solid content (described in the column of "Solvent") described in Table 2.

Then, by using an applicator, the composition 21 was uniformly applied on a release surface of a polyester film (NP-100A, manufactured by PANAC Corporation, film thickness: 100 µm), and the film was left for 1 hour under air to obtain a coating film 21.

Next, the coating film surface of the coating film 21 was covered with another polyester film, and was treated with a hot press under air (treated at a hot plate temperature of 80°C to 150°C (since liquid crystallinity differs according to a compound used, the hot plate temperature was appropriately adjusted according to the compound) and a pressure of 12 MPa for 30 minutes, treated at a temperature of 170°C and a pressure of 12 MPa for 30 minutes, and then treated at a temperature of 190°C for 2 hours) to cure the coating film and obtain a resin sheet. The polyester film on both surfaces of the resin sheet was peeled off, thereby obtaining a thermally conductive sheet 21 having an average film thickness of 250 µm.

In addition, using the coating film 21, liquid crystallinity at 150°C or lower was evaluated for the obtained composition 21 in the same manner as in Example 1. In addition, using the obtained thermal conduction sheet 21, thermal conductivity was evaluated in the same manner as in Example 1. Regarding Examples 21 to 37 and Comparative Examples 3 and 4, thermal conductivity was evaluated based on the following evaluation standard.

### (Evaluation standard)

"A": 15 W/m×K or more
"B": 12 W/m×K or more and less than 15 W/m×K
"C": 9 W/m×K or more and less than 12 W/m×K
"D": less than 9 W/m×K

### [Examples 22 to 37 and Comparative Examples 3 and 4]

Compositions of examples and comparative examples shown in Table 2 were obtained according to the same procedure as in Example 21.

In addition, the final solid contents of the compositions were adjusted using MEK so as to be the concentration of solid contents (described in the column of "Solvent") described in Table 2.

In addition, liquid crystallinity at 150°C or lower was evaluated for each of the obtained compositions in the same manner as in Example 21. Furthermore, from the obtained compositions, thermally conductive sheets 22 to 37 and comparative thermally conductive sheets 3 and 4 were produced, and these were subjected to the same evaluation test of thermal conductivity as in Example 1. The results are shown in Table 2.

Table 2 is shown below.

**[Table 2]**

| Table 2 (containing inorganic substance) | Composition of composition | | | | | | | | | | | | | | Liquid crystallinity of composition at temperature of 150°C or less | Evaluation result | |
|---|---|---|---|---|---|---|---|---|---|---|---|---|---|---|---|---|---|
| | Curing agent | | | | | Main agent | | | | | Inorganic substance | | Curing accelerator | Solvent (concentration of solid content (% by mass)) | | Thermal conductivity | Film thickness [µm] |
| | Type | | | | Content (% by mass) | Type | | | | Content (% by mass) | Type and mass ratio | Content (% by mass) | Content of triphenylphosphine (% by mass) | | | | |
| | Compound | Molecular shape | Partial structure of disk-like compound | Liquid crystallinity at temperature of 150°C or less | | Compound | Molecular shape | Partial structure of disk-like compoun d | Liquid crystallinity at temperature of 150°C or less | | | | | | | | |
| Example 21 | B-9 | Disk-like | CR4 | D_{Ne} | 20 | A-8 | Disk-like | CR4 | D_{Ne} | 20 | PTX-60/AA-3/AA-04= 60/30/10 | 60 | 0 | MEK (40) | D_{Ne} | A | 250 |
| Example 22 | B-1 | Disk-like | CR16 | D_{Ne} | 20 | A-4 | Disk-like | CR16 | D_{Ne} | 20 | PTX-60/AA-3/AA-04= 60/30/10 | 60 | 0 | MEK (40) | D_{Ne} | A | 250 |
| Example 23 | B-1 | Disk-like | CR16 | D_{Ne} | 20 | A-5 | Disk-like | CR16 | D_{Ne} | 20 | PTX-60/AA-3/AA-04= 60/30/10 | 60 | 0 | MEK (40) | D_{Ne} | A | 250 |
| Example 24 | B-1 | Disk-like | CR16 | D_{Ne} | 20 | A-6 | Disk-like | CR16 | D_{Ne} | 20 | PTX-60/AA-3/AA-04= 60/30/10 | 60 | 0 | MEK (40) | D_{Ne} | A | 250 |
| Example 25 | B-1 | Disk-like | CR16 | D_{Ne} | 20 | A-7 | Disk-like | CR16 | D_{Ne} | 20 | PTX-60/AA-3/AA-04= 60/30/10 | 60 | 0 | MEK (40) | D_{Ne} | A | 250 |
| Example 26 | B-2 | Disk-like | CR16 | D_{Ne} | 20 | A-4 | Disk-like | CR16 | D_{Ne} | 20 | PTX-60/AA-3/AA-04= 60/30/10 | 60 | 0 | MEK (40) | D_{Ne} | A | 250 |
| Example 27 | B-3 | Disk-like | CR16 | D_{Ne} | 20 | A-4 | Disk-like | CR16 | D_{Ne} | 20 | PTX-60/AA-3/AA-04= 60/30/10 | 60 | 0 | MEK (40) | D_{Ne} | A | 250 |
| Example 28 | B-4 | Disk-like | CR16 | D_{Ne} | 20 | A-4 | Disk-like | CR16 | D_{Ne} | 20 | PTX-60/AA-3/AA-04= 60/30/10 | 60 | 0 | MEK (40) | D_{Ne} | A | 250 |
| Example 29 | B-5 | Disk-like | CR16 | D_{Ne} | 20 | A-4 | Disk-like | CR16 | D_{Ne} | 20 | PTX-60/AA-3/AA-04= 60/30/10 | 60 | 0 | MEK (40) | D_{Ne} | A | 250 |
| Example 30 | B-6 | Disk-like | CR16 | D_{Ne} | 20 | A-4 | Disk-like | CR16 | D_{Ne} | 20 | PTX-60/AA-3/AA-04= 60/30/10 | 60 | 0 | MEK (40) | D_{Ne} | A | 250 |
| Example 31 | B-7 | Disk-like | CR16 | D_{Ne} | 20 | A-4 | Disk-like | CR16 | D_{Ne} | 20 | PTX-60/AA-3/AA-04= 60/30/10 | 60 | 0 | MEK (40) | D_{Ne} | A | 250 |
| Example 32 | B-10 | Rod-like | - | Ne | 24 | A-1 | Rod-like | - | Ne | 16 | PTX-60/AA-3/AA-04= 60/30/10 | 60 | 0 | MEK (40) | Ne | B | 250 |
| Example 33 | B-10 | Rod-like | - | Ne | 26 | A-3 | Rod-like | - | Ne | 14 | PTX-60/AA-3/AA-04-60/30/10 | 60 | 0 | MEK (40) | Ne | B | 250 |
| Example 34 | B-7 | Disk-like | CR16 | D_{Ne} | 20 | A-4 | Disk-like | CR16 | D_{Ne} | 20 | PT-110/AA-3/AA-04-6 0/30/10 | 60 | 0 | MEK (40) | D_{Ne} | B | 250 |
| Example 35 | B-7 | Disk-like | CR16 | D_{Ne} | 20 | A-4 | Disk-like | CR16 | D_{Ne} | 20 | S-50/AA-3/AA-04=60/3 0/10 | 60 | 0 | MEK (40) | D_{Ne} | B | 250 |
| Example 36 | B-7 | Disk-like | CR16 | D_{Ne} | 20 | A-4 | Disk-like | CR16 | D_{Ne} | 20 | SGPS/AA-3/AA-04=60/ 30/10 | 60 | 0 | MEK (40) | D_{Ne} | C | 250 |
| Example 37 | B-4 | Disk-like | CR16 | D_{Ne} | 20 | A-4 | Disk-like | CR16 | D_{Ne} | 20 | PTX-60/AA-3/AA-04= 60/30/10 | 59 | 1 | MEK (40) | D_{Ne} | A | 250 |
| Comparative Example 3 | BR-1 | Rod-like | - | - | 22 | A-1 | Rod-like | - | Sm | 18 | PTX-60/AA-3/AA-04= 60/30/10 | 60 | 0 | MEK (40) | - | D | 250 |
| Comparative Example 4 | BR-2 | Rod-like | - | - | 20 | A-2 | Rod-like | - | - | 20 | PTX-60/AA-3/AA-04= 60/30/10 | 60 | 0 | MEK (40) | - | D | 250 |

From the results in Table 2, according to the compositions of examples, it was clear that thermally conductive materials having excellent thermal conductivity can be formed.

In addition, from the results in Table 2, in a case where both of the curing agent and the main agent is a disk-like compound, it was confirmed that thermal conductivity is more excellent (refer to results of Example 32 and Examples 33).

In addition, from the results in Table 2, in a case where the inorganic substance has an average particle diameter of 20 µm or more (preferably 50 µm or more), it was confirmed that thermal conductivity is more excellent (compare Example 31, Example 34, and Example 36).

In addition, in a case where the inorganic substance includes boron nitride, it was confirmed that thermal conductivity is more excellent (compare Example 31 and Example 35).

On the other hand, none of the thermally conductive materials obtained from the compositions of comparative examples satisfied desired requirements.

## Claims

1. A composition comprising:
a curing agent including an active hydrogen-containing functional group; and
a main agent including a reactive group which reacts with the active hydrogen-containing functional group,
wherein the curing agent and the main agent respectively exhibit liquid crystallinity in a single state at a temperature of 150°C or lower.

2. The composition according to claim 1,
wherein the curing agent and the main agent respectively exhibit nematic liquid crystallinity in a single state at a temperature of 150°C or lower.

3. The composition according to claim 1 or 2,
wherein the main agent includes a ring-polymerizable group.

4. The composition according to any one of claims 1 to 3,
wherein the curing agent is a disk-like compound.

5. The composition according to any one of claims 1 to 4,
wherein the main agent is a disk-like compound.

6. The composition according to any one of claims 1 to 5,
wherein both of the curing agent and the main agent is a disk-like compound.

7. The composition according to any one of claims 4 to 6,
wherein the disk-like compound is a disk-like compound selected from the group consisting of a disk-like compound including a partial structure represented by Formula (CR4) and a disk-like compound including a partial structure represented by Formula (CR16), 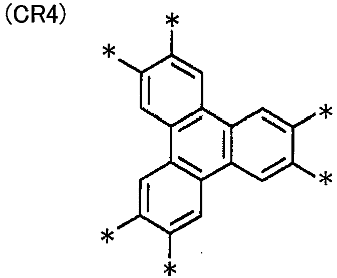 in the formula, * represents a bonding site, 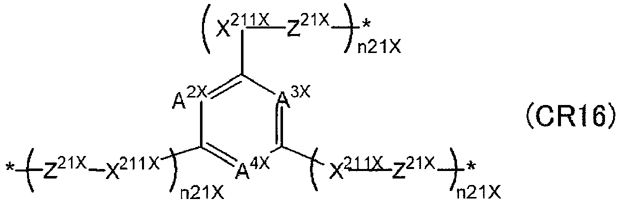
in the formula, a plurality of X^{211X}'s each independently represent a single bond, -O-, -C(=O)-, -NH-, -OC(=O)-, -OC(=O)O-, -OC(=O)NH-, -OC(=O)S-, -C(=O)O-, -C(=O)NH-, -C(=O)S-, -NHC(=O)-, -NHC(=O)O-, -NHC(=O)NH-, -NHC(=O)S-, -S-, -SC(=O)-, -SC(=O)O-, -SC(=O)NH-, or -SC(=O)S-,
a plurality of Z^{21X}'s each independently represent a 5-membered or 6-membered aromatic ring group or a 5-membered or 6-membered non-aromatic ring group,
all of A^{2X}, A^{3X} , and A^{4X} represent -CH=,
a plurality of n21X's each independently represent an integer of 0 to 3, and
* represents a bonding site.

8. The composition according to any one of claims 1 to 7, further comprising:
an inorganic substance.

9. The composition according to claim 8,
wherein the inorganic substance is an inorganic nitride or an inorganic oxide.

10. The composition according to claim 8 or 9,
wherein an average particle diameter of the inorganic substance is 20 µm or more.

11. The composition according to claim 8 or 9,
wherein the inorganic substance is boron nitride.

12. The composition according to any one of claims 1 to 11, which exhibits nematic liquid crystallinity.

13. The composition according to any one of claims 1 to 12, which is used for forming a thermally conductive material.

14. A method for manufacturing a thermally conductive material, the method comprising:
a step 1 of forming a composition layer using the composition according to any one of claims 1 to 13;
a step 2 of heating the composition layer to a temperature of 150°C or lower, at which both of the curing agent and the main agent exhibits liquid crystallinity, to align the curing agent and the main agent; and
a step 3 of curing the composition layer.

15. The method for manufacturing a thermally conductive material according to claim 14,
wherein the step 3 is a curing step using a thermosetting method.

16. A thermally conductive material formed by using the composition according to any one of claims 1 to 13.

17. The thermally conductive material according to claim 16, which is obtained by fixing a nematic liquid crystal phase.

18. The thermally conductive material according to claim 16 or 17, which is in a form of a sheet.

19. A device with a thermally conductive layer comprising:
a device; and
a thermally conductive layer which is disposed on the device and includes the thermally conductive material according to any one of claims 16 to 18.
